# EUROPEAN PATENT SPECIFICATION

(11) **EP 3 785 303 B1**
(45) Date of publication and mention of the grant of the patent: **13.08.2025**
(21) Application number: 19718847.7
(22) Date of filing: 16.04.2019
(51) Int. Cl.: H10K 59/35, H10K 50/115, H10K 50/11, H10K 85/50, H10K 59/80

(54) **PIXEL ARRANGEMENT COMPRISING A PEROVSKITE LIGHT EMITTING DIODE**
PIXELANORDNUNG MIT EINER PEROWSKIT-LEUCHTDIODE
AGENCEMENT DE PIXELS COMPRENANT UNE DIODE ÉLECTROLUMINESCENTE PÉROVSKITE

(30) Priority: 21.04.2018 GB 201806530
(43) Date of publication of application: 03.03.2021
(73) Proprietor: EXCYTON Limited, Sedgefield, County Durham TS21 3FD (GB)
(72) Inventor: LEVERMORE, Peter, Durham TS21 3FD (GB)
(74) Representative: Dehns
(86) International application number: PCT/GB2019/051086
(87) International publication number: WO 2019/202313

(56) References cited:
- WO-A1-2017/108962
- CN-A- 105 938 845
- CN-A- 107 768 529
- JI WENYU ET AL: "High color purity ZnSe/ZnS core/shell quantum dot based blue light emitting diodes with an inverted device structure", APPLIED PHYSICS LETTERS, vol. 103, no. 5, 29 July 2013 (2013-07-29), 2 Huntington Quadrangle, Melville, NY 11747, pages 053106, XP093032528, ISSN: 0003-6951, DOI: 10.1063/1.4817086
- JOU JWO-HUEI ET AL: "Efficient, color-stable fluorescent white organic light-emitting diodes with single emission layer by vapor deposition from solvent premixed deposition source", APPLIED PHYSICS LETTERS, AMERICAN INSTITUTE OF PHYSICS, 2 HUNTINGTON QUADRANGLE, MELVILLE, NY 11747, vol. 88, no. 19, 8 May 2006 (2006-05-08), pages 193501 - 193501, XP012081566, ISSN: 0003-6951, DOI: 10.1063/1.2200007
- LOREDANA PROTESESCU ET AL: "Nanocrystals of Cesium Lead Halide Perovskites (CsPbX 3 , X = Cl, Br, and I): Novel Optoelectronic Materials Showing Bright Emission with Wide Color Gamut", NANO LETTERS, vol. 15, no. 6, 2 February 2015 (2015-02-02), US, pages 3692 - 3696, XP055570565, ISSN: 1530-6984, DOI: 10.1021/nl5048779

## Description

### Technical Field

The present invention relates to pixel arrangements, which include one or more perovskite light emitting diodes, for application in devices, such as displays, and other devices including the same.

### Background

Perovskite materials are becoming increasingly attractive for application in optoelectronic devices. Many of the perovskite materials used to make such devices are earth-abundant and relatively inexpensive, so perovskite optoelectronic devices have the potential for cost advantages over alternative organic and inorganic devices. Additionally, inherent properties or perovskite materials, such as an optical band gap that is readily tunable across the visible, ultra-violet and infra-red, render them well suited for optoelectronics applications, such as perovskite light emitting diodes (PeLEDs), perovskite solar cells and photodetectors, perovskite lasers, perovskite transistors, perovskite visible light communication (VLC) devices and others. PeLEDs comprising perovskite light emitting material may have performance advantages over conventional organic light emitting diodes (OLEDs) and quantum dot light emitting diodes (QLEDs), respectively comprising organic light emitting material and quantum dot light emitting material. For example, strong electroluminescent properties, including unrivalled high colour purity enabling displays with wider colour gamut, excellent charge transport properties and low non-radiative rates.

PeLEDs make use of thin perovskite films that emit light when voltage is applied. PeLEDs are becoming an increasingly attractive technology for use in applications such as displays, lighting and signage. As an overview, several PeLED materials and configurations are described in Adjokatse et al. Displays with PeLED sub-pixels are described in CN 105 938 845 A and CN 107 768 529 A.

One potential application for perovskite light-emitting materials is a display. Industry standards for a full-colour display require for sub-pixels to be engineered to emit specific colours, referred to as "saturated" colours. These standards call for saturated red, green and blue sub-pixels, where colour may be measured using CIE coordinates, which are well known in the art. One example of a perovskite material that emits red light is methylammonium lead iodide (CH₃NH₃Pbl₃). One example of a perovskite material that emits green light is formamidinium lead bromide (CH(NH₂)₂PbBr₃). One example of a perovskite material that emits blue light is methylammonium lead chloride (CH₃NH₃PbCl₃). In a display, performance advantages, such as increased colour gamut, may be achieved where PeLEDs are used in place of or in combination with OLEDs and/or QLEDs.

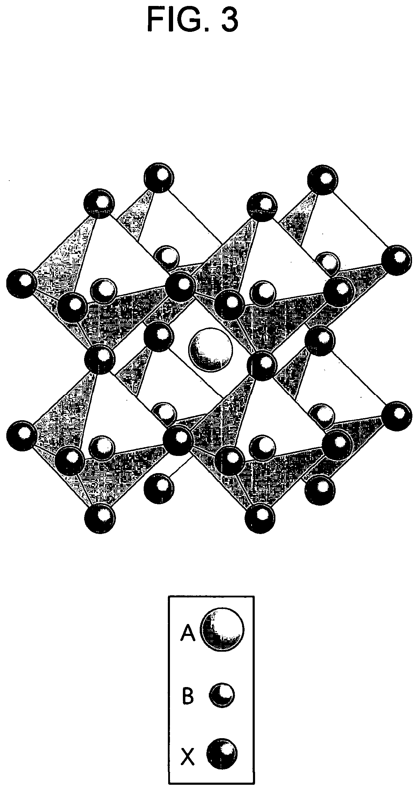

As used herein, the term "perovskite" includes any perovskite material that may be used in an optoelectronic device. Any material that may adopt a three-dimensional (3D) structure of ABX₃, where A and B are cations and X is an anion, may be considered a perovskite material. FIG. **3** depicts an example of a perovskite material with a 3D structure of ABX₃. The A cations may be larger than the B cations. The B cations may be in 6-fold coordination with surrounding X anions. The A anions may be in 12-fold coordination with surrounding X anions.

There are many classes of perovskite material. One class of perovskite material that has shown particular promise for optoelectronic devices is the metal halide perovskite material class. For metal halide perovskite material, the A component may be a monovalent organic cation, such as methylammonium (CH₃NH₃⁺) or formamidinium (CH(NH₂)₂⁺), an inorganic atomic cation, such as caesium (Cs⁺), or a combination thereof, the B component may be a divalent metal cation, such as lead (Pb⁺), tin (Sn⁺), copper (Cu⁺), europium (Eu⁺) or a combination thereof, and the X component may be a halide anion, such as I⁻, Br, Cl⁻, or a combination thereof. Where the A component is an organic cation, the perovskite material may be defined as an organic metal halide perovskite material. CH₃NH₃PbBr₃ and CH(NH₂)₂Pbl₃ are non-limiting examples of organic metal halide perovskite materials with a 3D structure. Where the A component is an inorganic cation, the perovskite material may be defined as an inorganic metal halide perovskite material. CsPbl₃, CsPbCl₃ and CsPbBr₃ are non-limiting examples of inorganic metal halide perovskite materials.

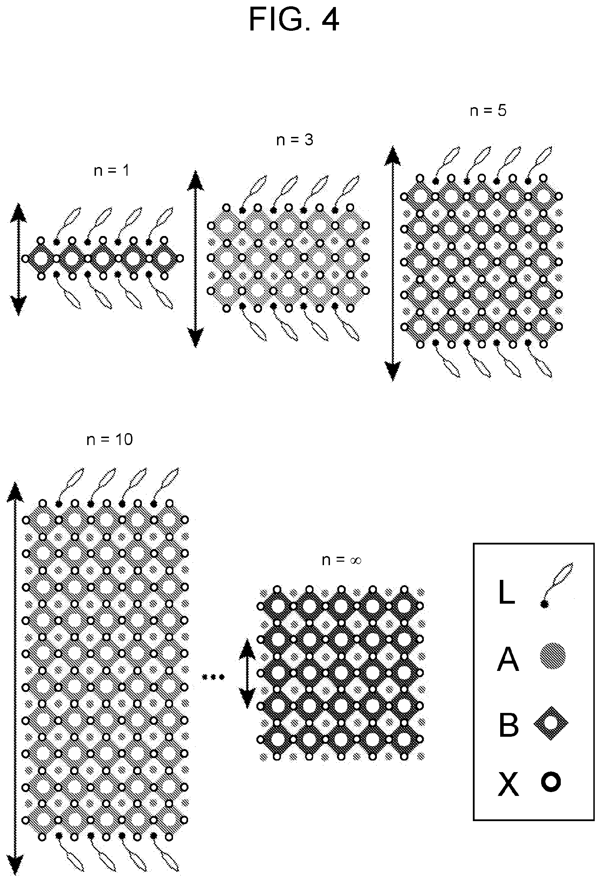

As used herein, the term "perovskite" further includes any material that may adopt a layered structure of L₂(ABX₃)ₙ₋₁BX₄ (which may also be written as L₂Aₙ₋₁BₙX₃ₙ₊₁), where L, A and B are cations, X is an anion, and n is the number of BX₄ monolayers disposed between two layers of cation L. FIG. **4** depicts examples of perovskite materials with a layered structure of L₂(ABX₃)ₙ₋₁BX₄ having different values for n. For metal halide perovskite material, the A component may be a monovalent organic cation, such as methylammonium (CH₃NH₃⁺) or formamidinium (CH(NH₂)₂⁺), an atomic cation, such as caesium (Cs⁺), or a combination thereof, the L component may be an organic cation such as 2-phenylethylammonium (C₆H₅C₂H₄NH₃⁺) or 1-napthylmethylammonium (C₁₀H₇CH₂NH₃⁺), the B component may be a divalent metal cation, such as lead (Pb⁺), tin (Sn⁺), copper (Cu⁺), europium (Eu⁺) or a combination thereof, and the X component may be a halide anion, such as I⁻, Br⁻, Cl⁻, or a combination thereof. (C₆H₅C₂H₄NH₃)₂(CH(NH₂)₂PbBr₃)ₙ₋₁PbBr₄ and (C₁₀H₇CH₂NH₃)₂(CH₃NH₃PbI₂Br)ₙ₋₁PbI₃Br are non-limiting examples of metal halide perovskite material with a layered structure.

Where the number of layers n is large, for example n greater than approximately 10, perovskite material with a layered structure of L₂(ABX₃)ₙ₋₁BX₄ adopts a structure that is approximately equivalent to perovskite material with a 3D structure of ABX₃. As used herein, and as would generally be understood by one skilled in the art, perovskite material having a large number of layers may be referred to as a 3D perovskite material, even though it is recognized that such perovskite material has reduced dimensionality from n = ∞. Where the number of layers n = 1, perovskite material with a layered structure of L₂(ABX₃)ₙ₋₁BX₄ adopts a two-dimensional (2D) structure of L₂BX₄. Perovskite material having a single layer may be referred to as a 2D perovskite material. Where n is small, for example n in the range of approximately 2-10, perovskite material with a layered structure of L₂(ABX₃)ₙ₋₁BX₄ adopts a quasi-two-dimensional (Quasi-2D) structure. Perovskite material having a small number of layers may be referred to as a Quasi-2D perovskite material. Owing to quantum confinement effects, the energy band gap is lowest for layered perovskite material structures where n is highest.

Perovskite material may have any number of layers. Perovskites may comprise 2D perovskite material, Quasi-2D perovskite material, 3D perovskite material or a combination thereof. For example, perovskites may comprise an ensemble of layered perovskite materials having a different numbers of layers. For example, perovskites may comprise an ensemble of Quasi-2D perovskite materials having a different numbers of layers.

As used herein, the term "perovskite" further includes films of perovskite material. Films of perovskite material may be crystalline, polycrystalline or a combination thereof, with any number of layers and any range of grain or crystal size.

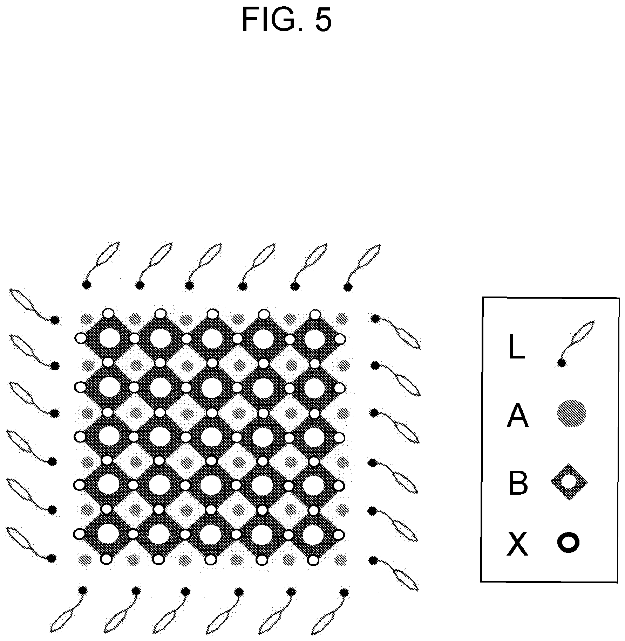

As used herein, the term "perovskite" further includes nanocrystals of perovskite material that have structure equivalent to or resembling the 3D perovskite structure of ABX₃ or the more general layered perovskite structure of L₂(ABX₃)ₙ₋₁BX₄. Nanocrystals of perovskite material may include perovskite nanoparticles, perovskite nanowires, perovskite nanoplatelets, or a combination thereof. Nanocrystals of perovskite material may be of any shape or size, with any number of layers and any range of grain or crystal sizes. FIG. **5** depicts an example of nanocrystal of perovskite material with a layered structure that resembles L₂(ABX₃)ₙ₋₁BX₄, where n = 5 and L cations are arranged at the surface of the perovskite nanocrystal. The term "resembles" is used because for a nanocrystal of perovskite material, the distribution of L cations may differ from that of perovskite material with a formal layered structure of L₂(ABX₃)ₙ₋₁BX₄. For example, in a nanocrystal of perovskite material, there may be a greater proportion of L cations arranged along the side of the nanocrystal.

Several types of perovskite material may be stimulated to emit light in response to optical or electrical excitation. That is to say that perovskite light emitting material may be photoluminescent or electroluminescent. As used herein, the term "perovskite light emitting material" refers exclusively to electroluminescent perovskite light emitting material that is emissive through electrical excitation. Wherever "perovskite light emitting material" is referred to in the text, it should be understood that reference is being made to electroluminescent perovskite light emitting material. This nomenclature may differ slightly from that used by other sources.

In general, PeLED devices may be photoluminescent or electroluminescent. As used herein, the term "PeLED" refers exclusively to electroluminescent PeLED devices that comprise electroluminescent perovskite light emitting material. This nomenclature may differ slightly from that used by other sources.

As used herein, the term "organic" includes polymeric materials as well as small molecule organic materials that may be used to fabricate optoelectronic devices, such as OLEDs. As used herein, the term small molecule refers to any organic material that is not a polymer, and small molecules may actually be quite large. Small molecules may include repeat units in some circumstances. For example, using a long chain alkyl group as a substituent does not remove a molecule from the small molecule class. Small molecules may also be incorporated into polymers, for example as a pendant group on a polymer backbone or as part of the backbone. Small molecules may also serve as the core moiety of a dendrimer, which consists of a series of chemical shells built on the core moiety. The core moiety of a dendrimer may be a small molecule. A dendrimer may be a small molecule and it is believed that all dendrimers currently used in the field of OLEDs are small molecules.

As used herein the term "organic light emitting material" includes fluorescent and phosphorescent organic light emitting materials, as well as organic materials that emit light through mechanisms such as triplet-triplet annihilation (TTA) or thermally activated delayed fluorescence (TADF). One example of organic light emitting material that emits red light is Bis(2-(3,5-dimethylphenyl)quinoline-C2,N') (acetylacetonato) iridium(III) Ir(dmpq)₂(acac). One example of organic light emitting material that emits green light is tris(2-phenylpyridine)iridium (Ir(ppy)₃). One example of organic light emitting material that emits blue light is Bis[2-(4,6-difluorophenyl)pyridinato-C2,N](picolinato)iridium(III) (Flrpic).

As used herein, the term "quantum dot" includes quantum dot material, quantum rod material and other luminescent nanocrystal material, with the exception of "perovskite" material, which is defined separately herein. Quantum dots may generally be considered as semiconductor nanoparticles that exhibit properties that are intermediate between bulk semiconductors and discrete molecules. Quantum dots may comprise III-V semiconductor material, such as gallium nitride (GaN), gallium phosphide (GaP), gallium arsenide (GaAs), indium phosphide (InP) and indium arsenide (InAs), or II-VI semiconductor material, such as zinc oxide (ZnO), zinc sulfide (ZnS), cadmium sulfide (CdS), cadmium selenide (CdSe) and cadmium telluride (CdTe), or combinations thereof. In general, as a result of quantum confinement effects, optoelectronic properties of quantum dots may change as a function of size or shape of the quantum dot.

Several types of quantum dot may be stimulated to emit light in response to optical or electrical excitation. That is to say that quantum dot light emitting material may be photoluminescent or electroluminescent. As used herein, the term "quantum dot light emitting material" refers exclusively to electroluminescent quantum dot light emitting material that is emissive through electrical excitation. Wherever "quantum dot light emitting material" is referred to in the text, it should be understood that reference is being made to electroluminescent quantum dot light emitting material. This nomenclature may differ slightly from that used by other sources.

As used herein, the term "quantum dot" does not include "perovskite" material. Several types of perovskite material, such as perovskite nanocrystals, 2D perovskite materials and Quasi-2D perovskite materials, are semiconducting materials that exhibit properties intermediate between bulk semiconductors and discrete molecules, where in a similar manner to quantum dots, quantum confinement may effect optoelectronic properties. However, as used herein, such materials are referred to as "perovskite" materials and not "quantum dot" materials. A first reason for this nomenclature is that perovskite materials and quantum dot materials, as defined herein, generally comprise different crystal structures. A second reason for this nomenclature is that perovskite materials and quantum dot materials, as defined herein, generally comprise different material types within their structures. A third reason for this nomenclature is that emission from perovskite material is generally independent of the structural size of the perovskite material, whereas emission from quantum dot material is generally dependent on the structural size (e.g. core and shell) of the quantum dot material. This nomenclature may differ slightly from that used by other sources.

In general, quantum dot light emitting materials comprise a core. Optionally, the core may be surrounded by one or more shells. Optionally, the core and one or more shells may be surrounded by a passivation structure. Optionally, the passivation structure may comprise ligands bonded to the one or more shells. The size of the of the core and shell(s) may influence the optoelectronic properties of quantum dot light emitting material. Generally, as the size of the core and shell(s) is reduced, quantum confinement effects become stronger, and electroluminescent emission may be stimulated at shorter wavelength. For display applications, the diameter of the core and shell(s) structure is typically in the range of 1- 10nm. Quantum dots that emit blue light are typically the smallest, with core-shell(s) diameter in the approximate range of 1 - 2.5nm. Quantum dots that emit green light are typically slightly larger, with core-shell(s) diameter in the approximate range of 2.5 - 4nm. Quantum dots that emit red light are typically larger, with core-shell(s) diameter in the approximate range of 5-7nm. It should be understood that these ranges are provided by way of example and to aid understanding, and are not intended to be limiting.

Examples of quantum dot light emitting materials include materials comprising a core of CdSe. CdSe has a bulk bandgap of 1.73 eV, corresponding to emission at 716nm. However, the emission spectrum of CdSe may be adjusted across the visible spectrum by tailoring the size of the CdSe quantum dot. Quantum dot light emitting materials comprising a CdSe core may further comprise one or more shells, comprising CdS, ZnS or combinations thereof. Quantum dot light emitting materials comprising CdSe may further comprise a passivation structure, which may include ligands bonded to the shell(s). Quantum dot light emitting materials comprising CdSe/CdS or CdSe/ZnS core-shell structures may be tuned to emit red, green or blue light for application in displays.

Examples of quantum dot light emitting materials further include materials comprising a core of InP. InP has a bulk bandgap of 1.35 eV, corresponding to emission at 918nm. However, the emission spectrum of InP may be adjusted across the visible spectrum by tailoring the size of the InP quantum dot. Quantum dot light emitting materials comprising a InP core may further comprise one or more shells of CdS, ZnS or combinations thereof. Quantum dot light emitting materials comprising InP may further comprise a passivation structure, which may include ligands bonded to the shell(s). Quantum dot light emitting materials comprising InP/CdS or InP/ZnS core-shell structures may be tuned to emit red, green or blue light for application in displays.

In general, QLED devices may be photoluminescent or electroluminescent. As used herein, the term "QLED" refers exclusively to electroluminescent QLED devices that comprise electroluminescent quantum dot light emitting material. This nomenclature may differ slightly from that used by other sources.

As used herein, "top" means furthest away from the substrate, while "bottom" means closest to the substrate. Where a first layer is described as "disposed over" a second layer, the first layer is disposed further away from the substrate. There may be other layers between the first and second layer, unless it is specified that the first layer is "in contact with" the second layer.

As used herein, "solution processible" means capable of being dissolved, dispersed or transported in and/or deposited from a liquid medium, either in solution or suspension form.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) and electron affinities (EA) are measured as negative energies relative to a vacuum level, a higher HOMO energy level corresponds to an IP that is less negative. Similarly, a higher LUMO energy level corresponds to an EA that is less negative. On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. The definitions of HOMO and LUMO energy levels therefore follow a different convention than work functions.

As used herein, "flexible structure" means a structure that is operable while flexed. One useful measure of the balance between flexibility and rigidity is flexural rigidity. This is defined as a force couple required to bend a rigid structure to a unit curvature. For a uniform substrate, flexural rigidity can be described mathematically as: D = Et³ / (12(1-µ²)), where D is the flexural rigidity (in Nm), E is Young's modulus (in Nm⁻²), µ is Poisson's ratio and t is the thickness of the structure (in m). The more flexible the structure, the lower the flexural rigidity. The flexural rigidity of any structure can be theoretically calculated if Young's modulus, Poisson's ratio and the thickness of the structure are known. However, in practice, especially when dealing with thin films, flexural rigidity may be affected by processing details, lamination of additional layers, non-uniformity across the film and the like. A preferred approach is to measure the flexural rigidity of the structure. This can be done using the principle of the heavy elastica, as described in United States patent US 8773013 B2.

As used herein, the term "optically coupled" refers to one or more elements of a device or structure that are arranged such that light may impart between the one or more elements. The one or more elements may be in contact or may be separated by a gap or any connection, coupling, link or the like that allows for imparting of light between the one or more elements. For example, one or more sub-pixels within a pixel arrangement of a display may be optically coupled to one or more colour altering layers through a transparent or semi-transparent substrate.

### Summary

A pixel arrangement for application in a display is provided as defined in claim 1.

In one embodiment one of the first, second and third sub-pixels emits red light; one of the first, second and third sub-pixels emits green light; and one of the first, second and third pixels emits blue light. In one embodiment, one of the first, second and third sub-pixels emits red light with CIE 1931 x coordinate greater than or equal to 0.680; one of the first, second and third sub-pixels emits green light with CIE 1931 y coordinate greater than or equal to 0.690; and one of the first, second and third sub-pixels emits blue light with CIE 1931 y coordinate less than or equal to 0.060. In one embodiment, one of the first, second and third sub-pixels emits red light with CIE 1931 x coordinate greater than or equal to 0.708; one of the first, second and third sub-pixels emits green light with CIE 1931 y coordinate greater than or equal to 0.797; and one of the first, second and third sub-pixels emits blue light with CIE 1931 y coordinate less than or equal to 0.046.

The first, second and third sub-pixels of the pixel arrangement may have the same surface area, or at least one of the first, second and third sub-pixels has a surface area different from another of the first, second and third sub-pixels.

In one embodiment, the pixel arrangement may further comprise a fourth sub-pixel configured to emit a fourth colour of light that is different from the first, second and third colour of light, the fourth sub-pixel comprising a PeLED, an OLED or a QLED.

In one embodiment, one or more PeLEDs within the pixel arrangement may comprise organic metal halide light-emitting perovskite material. In one embodiment, one or more PeLEDs within the pixel arrangement may comprise inorganic metal halide light-emitting perovskite material.

In one embodiment, the pixel arrangement may be included in a display. In one embodiment, each of the sub-pixels of the display include a microcavity structure. In one embodiment, at least one of sub-pixels of the display includes a microcavity structure. In one embodiment, each of the sub-pixels of the display include a colour altering layer. In one embodiment, at least one of the sub-pixels of the display includes a colour altering layer. In one embodiment, the display is a flexible structure. In one embodiment, the display is part of a consumer product. In one embodiment, the display is capable of rendering the DCI-P3 colour gamut. In one embodiment, the display is capable of rendering the Rec. 2020 colour gamut.

### Description of the Drawings

The summary above, as well as the following detailed description of illustrative embodiments, is better understood when read in conjunction with the appended drawings. For the purpose of illustrating the present disclosure, exemplary constructions of the disclosure are shown in the drawings. However, the present disclosure is not limited to specific methods and instrumentalities disclosed herein. Moreover, those in the art will understand that the drawings are not to scale.

In the accompanying drawings, an underlined number is employed to represent an item over which the underlined number is positioned or an item to which the underlined number is adjacent. A non-underlined number relates to an item identified by a line linking the non-underlined number to the item. When a number is non-underlined and accompanied by an associated arrow, the non-underlined number is used to identify a general item at which the arrow is pointing. Embodiments of the present disclosure will now be described, by way of example only, with reference to the following:
FIG. **1** depicts a light emitting device.
FIG. **2** depicts an inverted light emitting device.
FIG. **3** depicts 3D perovskite light emitting material with structure ABX₃.
FIG. **4** depicts layered perovskite light emitting material with structure L₂(ABX₃)ₙ₋₁BX₄, where n = 1, 3, 5, 10 and ∞.
FIG. **5** depicts an example of a nanocrystal of perovskite materials with a layered structure that resembles L₂(ABX₃)ₙ₋₁BX₄, where n = 5.
FIG. **6** depicts a rendition of the CIE 1931 (x, y) colour space chromaticity diagram.
FIG. **7** depicts a rendition of the CIE 1931(x, y) colour space chromaticity diagram that also shows colour gamut for (a) DCI-P3 and (b) Rec. 2020 colour spaces
FIG. **8** depicts a rendition of the CIE 1931 (x, y) color space chromaticity diagram that also shows colour gamut for (a) DCI-P3 and (b) Rec. 2020 colour spaces with colour coordinates for exemplary red, green and blue PeLED, OLED and QLED devices.
FIG. **9** depicts exemplary electroluminescence emission spectra for red, green and blue PeLEDs, OLEDs and QLEDs.
FIG. **10** depicts various pixel arrangement configurations that comprise various combinations of light emitting diodes.
FIG. **11** depicts various configurations of sub-pixel layout and size for a pixel arrangement having three sub-pixels.
FIG. **12** depicts various configurations of sub-pixel layout and size for a pixel arrangement having four sub-pixels.
FIG. **13** depicts cross-sections of various configurations for a display comprising one or more colour altering layers.

### Description of Embodiments

General device architectures and operating principles for PeLEDs are substantially similar to those for OLEDs and QLEDs. Each of these types of light emitting devices comprises at least one emissive layer disposed between and electrically connected to an anode and a cathode. For a PeLED, the emissive layer comprises perovskite light emitting material. For an OLED, the emissive layer comprises organic light emitting material. For a QLED, the emissive layer comprises quantum dot light emitting material. For each of these light emitting devices, when a current is applied, the anode injects holes and the cathode injects electrons into the emissive layer(s). The injected holes and electrons each migrate towards the oppositely charged electrode. When an electron and a hole localize, an exciton, which is a localized electron-hole pair having an excited energy state, may be formed. Light is emitted if the exciton relaxes via a photo-emissive mechanism. Non-radiative mechanisms, such as thermal radiation and/or Auger recombination may also occur, but are generally considered undesirable. Substantial similarity between device architectures and working principles required for PeLEDs, OLEDs and QLEDs, facilitates the combination of these light emitting devices in a single device, such as a display.

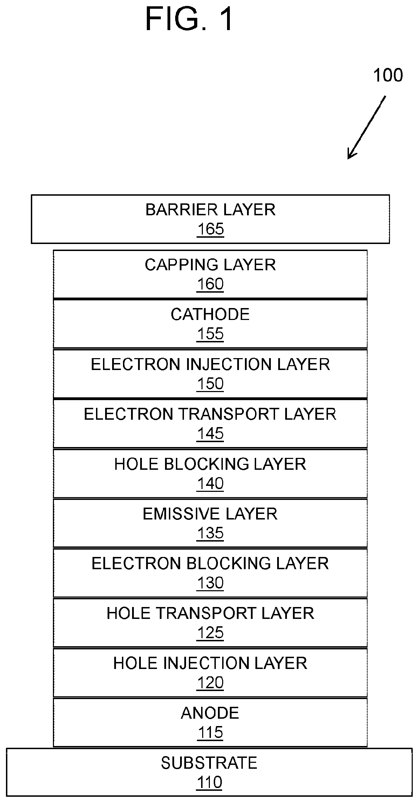

FIG. 1 shows a light emitting device **100.** The light emitting device **100** may be a PeLED, OLED or QLED. Device **100** may include a substrate **110,** an anode **115,** a hole injection layer **120,** a hole transport layer **125,** an electron blocking layer **130,** an emissive layer **135,** a hole blocking layer **140,** an electron transport layer **145,** an electron injection layer **150,** a cathode **155,** a capping layer **160,** and a barrier layer **165.** Device **100** may be fabricated by depositing the layers described in order. As the device **100** has anode **115** disposed under cathode **155,** device **100** may be referred to as a "standard" device architecture. For a PeLED, the emissive layer comprises perovskite light emitting material. For an OLED, the emissive layer comprises organic light emitting material. For a QLED, the emissive layer comprises quantum dot light emitting material.

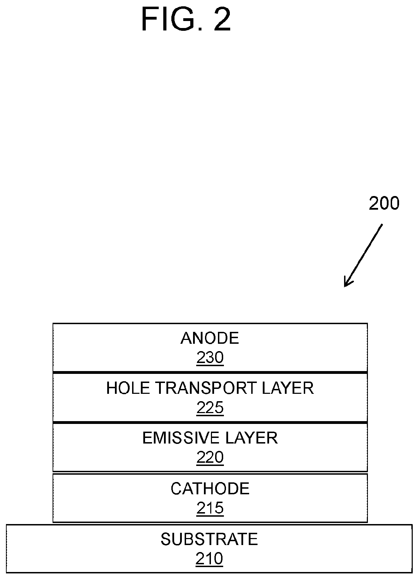

FIG. **2** shows an inverted light emitting device **200.** The light emitting device **200** may be a PeLED, OLED or QLED. The device includes a substrate **210,** a cathode **215,** an emissive layer **220,** a hole transport layer **225,** and an anode **230.** Device **200** may be fabricated by depositing the layers described in order. As the device **200** has cathode **215** disposed under anode **230,** device **200** may be referred to as an "inverted" device architecture. For a PeLED, the emissive layer comprises perovskite light emitting material. For an OLED, the emissive layer comprises organic light emitting material. For a QLED, the emissive layer comprises quantum dot light emitting material. Materials similar to those described with respect to device **100** may be used in the corresponding layers of device **200.** FIG. **2** provides one example of how some layers may be omitted from the structure of a PeLED, OLED or QLED.

The simple layered structures illustrated in FIGS. **1** and **2** are provided by way of non-limiting examples, and it is understood that embodiments of the invention may be used in connection with a wide variety of other structures. The specific materials and structures described are exemplary in nature, and other materials and structures may be used. Functional PeLEDs, OLEDs and QLEDs may be achieved by combining the various layers described in different ways, or layers may be omitted entirely, based on factors such as performance, design and cost. Other layers, not specifically described, may also be included. Materials other than those specifically described may be used. Although many of the examples provided herein describe various layers as comprising a single material, it is understood that combinations of materials may be used. Also, the layers may have various sublayers. The names given to the various layers herein are not intended to be strictly limiting. For example, in a device, the hole transport layer may transport and injects holes into the emissive layer and may be described as a hole transport layer or a hole injection layer.

PeLEDs, OLEDs and QLEDs are generally intended to emit light through at least one of the electrodes, and one or more transparent electrodes may be useful in such optoelectronic devices. For example, a transparent electrode material, such as indium tin oxide (ITO), may be used for the bottom electrode, while a transparent electrode material, such as a thin metallic layer of a blend of magnesium and silver (Mg:Ag), may be used for the top electrode. For a device intended to emit light only through the bottom electrode, the top electrode does not need to be transparent, and may be comprised of an opaque and/or reflective layer, such as a metal layer having a high reflectivity. Similarly, for a device intended only to emit light through the top electrode, the bottom electrode may be opaque and/or reflective, such as a metal layer having a high reflectivity. Where an electrode does not need to be transparent, using a thicker layer may provide better conductivity and may reduce voltage drop and/or Joule heating in the device, and using a reflective electrode may increase the amount of light emitted through the other electrode by reflecting light back towards the transparent electrode. A fully transparent device may also be fabricated, where both electrodes are transparent.

Devices fabricated in accordance with embodiments of the present invention may optionally comprise a substrate **110.** The substrate **110** may comprise any suitable material that provides the desired structural and optical properties. The substrate **110** may be rigid or flexible. The substrate **110** may be flat or curved. The substrate **110** may be transparent, translucent or opaque. Preferred substrate materials are glass, plastic and metal foils. Other substrates, such as fabric and paper may be used. The material and thickness of the substrate **110** may be chosen to obtain desired structural and optical properties. Substantial similarity between substrate properties required for PeLEDs, OLEDs and QLEDs facilitates the combination of these light emitting devices in a single device, such as a display.

Devices fabricated in accordance with embodiments of the present invention may optionally comprise an anode **115.** The anode **115** may comprise any suitable material or combination of materials known to the art, such that the anode **115** is capable of conducting holes and injecting them into the layers of the device. Preferred anode **115** materials include conductive metal oxides, such as indium tin oxide (ITO), indium zinc oxide (IZO) and aluminum zinc oxide (AlZnO), metals such as silver (Ag), aluminum (Al), aluminum-neodymium (Al:Nd), gold (Au) and alloys thereof, or a combination thereof. Other preferred anode **115** materials include graphene, carbon nanotubes, nanowires or nanoparticles, silver nanowires or nanoparticles, organic materials, such as poly(3,4-ethylenedioxythiophene) : polystyrene sulfonate (PEDOT:PSS) and derivatives thereof, or a combination thereof. Compound anodes comprising one or more anode materials in a single layer may be preferred for some devices. Multilayer anodes comprising one or more anode materials in one or more layers may be preferred for some devices. One example of a multilayer anode is ITO/Ag/ITO. In a standard device architecture for PeLEDs, OLEDs and QLEDs, the anode **115** may be sufficiently transparent to create a bottom-emitting device, where light is emitted through the substrate. One example of a transparent anode commonly used in a standard device architecture is a layer of ITO. Another example of a transparent anode commonly used in a standard device architecture is ITO/Ag/ITO, where the Ag thickness is less than approximately 25nm. By including a layer of silver of thickness less than approximately 25nm, the anode may be transparent as well as partially reflective. When such a transparent and partially reflective anode is used in combination with a reflective cathode, such as LiF/Al, this may have the advantage of creating a microcavity effect within the device. A microcavity may provide one or more of the following advantages: an increased total amount of light emitted from device, and therefore higher efficiency and brightness; an increased proportion of light emitted in the forward direction, and therefore increased apparent brightness at normal incidence; and spectral narrowing of the emission spectrum, resulting in light emission with increased colour saturation. The anode **115** may be opaque and/or reflective. In a standard device architecture for PeLEDs, OLEDs and QLEDs, a reflective anode **115** may be preferred for some top-emitting devices to increase the amount of light emitted from the top of the device. One example of a reflective anode commonly used in a standard device architecture is a multilayer anode of ITO/Ag/ITO, where the Ag thickness is greater than approximately 80nm. When such a reflective anode is used in combination with a transparent and partially reflective cathode, such as Mg:Ag, this may have the advantage of creating a microcavity effect within the device. A microcavity may provide one or more of the following advantages: an increased total amount of light emitted from device, and therefore higher efficiency and brightness; an increased proportion of light emitted in the forward direction, and therefore increased apparent brightness at normal incidence; and spectral narrowing of the emission spectrum, resulting in light emission with increased colour saturation. The material and thickness of the anode **115** may be chosen to obtain desired conductive and optical properties. Where the anode **115** is transparent, there may be a range of thicknesses for a particular material that is thick enough to provide the desired conductivity, yet thin enough to provide the desired degree of transparency. Other materials and structures may be used. Substantial similarity between anode properties required for PeLEDs, OLEDs and QLEDs facilitates the combination of these light emitting devices in a single device, such as a display.

Devices fabricated in accordance with embodiments of the present invention may optionally comprise a hole transport layer **125.** The hole transport layer **125** may include a material capable of transporting holes. The hole transport layer **125** may be deposited by a solution process or by a vacuum deposition process. The hole transport layer **125** may be doped or undoped. Doping may be used to enhance conductivity.

Examples of undoped hole transport layers are N,N'-Di(1-naphthyl)-N,N'-diphenyl-(1,1'-biphenyl)-4,4'-diamine (NPD), poly[(9,9-dioctylfluorenyl-2,7-diyl)-co -(4,4'-(N -(4-sec-butylphenyl) diphenylamine (TFB), poly[N,N'-bis(4-butylphenyl)-N,N'-bis(phenyl)-benzidine] (poly-TPD), poly(9-vinylcarbazole) (PVK), 4,4'-Bis(N-carbazolyl)-1,1'-biphenyl (CBP), Spiro-OMeTAD and molybdenum oxide (MoO₃). One example of a doped hole transport layer is 4,4',4"-Tris[phenyl(m-tolyl)amino]triphenylamine (m-MTDATA) doped with F₄-TCNQ at a molar ratio of 50:1. One example of a solution-processed hole transport layer is PEDOT:PSS. Other hole transport layers and structures may be used. The preceding examples of hole transport materials are all especially well-suited to application in PeLEDs. However, these materials may also be implemented effectively in OLEDs and QLEDs. Substantial similarity between hole transport layer properties required for PeLEDs, OLEDs and QLEDs facilitates the combination of these light emitting devices in a single device, such as a display.

Devices fabricated in accordance with embodiments of the present invention may optionally comprise an emissive layer **135.** The emissive layer **135** may include material capable of emitting light when a current is passed between anode **115** and cathode **155.** Device architectures and operating principles are substantially similar for PeLEDs, OLEDs and QLEDs. However, these light emitting devices may be distinguished by differences in their respective emissive layers. The emissive layer of a PeLED may comprise perovskite light emitting material. The emissive layer of an OLED may comprise organic light emitting material. The emissive layer of a QLED may comprise quantum dot light emitting material.

Examples of perovskite light-emitting materials include 3D perovskite materials, such as methylammonium lead iodide (CH₃NH₃PbI₃), methylammonium lead bromide (CH₃NH₃PbBr₃), methylammonium lead chloride (CH₃NH₃PbCl₃), formamidinium lead iodide (CH(NH₂)₂PbI₃), formamidinium lead bromide (CH(NH₂)₂PbBr₃), formamidinium lead chloride (CH(NH₂)₂PbCl₃), caesium lead iodide (CsPbI₃), caesium lead bromide (CsPbBr₃) and caesium lead chloride (CsPbCl₃). Examples of perovskite light-emitting materials further include 3D perovskite materials with mixed halides, such as CH₃NH₃PbI₃₋ₓClₓ, CH₃NH₃PbI₃₋ₓBrₓ, CH₃NH₃PbCl₃₋ₓBrₓ, CH(NH₂)₂PbI₃₋ₓBrₓ, CH(NH₂)₂PbI₃₋ₓClₓ, CH(NH₂)₂PbCl₃₋ₓBrₓ, CsPbI₃₋ₓClₓ, CsPbI₃₋ₓBrₓ and CsPbCl₃₋ₓBrₓ, where x is in the range of 0-3. Examples of perovskite light-emitting materials further include 2D perovskite materials such as (C₁₀H₇CH₂NH₃)₂PbI₄, (C₁₀H₇CH₂NH₃)₂PbBr₄, (C₁₀H₇CH₂NH₃)₂PbCl₄, (C₆H₅C₂H₄NH₃)₂PbI₄, (C₆H₅C₂H₄NH₃)₂PbBr₄ and (C₆H₅C₂H₄NH₃)₂PbCl₄, 2D perovskite materials with mixed halides, such as (C₁₀H₇CH₂NH₃)₂PbI₃₋ₓCₓ, (C₁₀H₇CH₂NH₃)₂PbI₃₋ₓBrₓ, (C₁₀H₇CH₂NH₃)₂PbCl₃₋ₓBrₓ, (C₆H₅C₂H₄NH₃)₂PbI₃₋ₓClₓ, (C₆H₅C₂H₄NH₃)₂PbI₃₋ₓBrₓ and (C₆H₅C₂H₄NH₃)₂PbCl₃₋ₓBrₓ, where x is in the range of 0-3. Examples of perovskite light-emitting materials further include Quasi-2D perovskite materials, such as (C₆H₅C₂H₄NH₃)₂(CH(NH₂)₂PbBr₃)ₙ₋₁PbI₄, (C₆H₅C₂H₄NH₃)₂(CH(NH₂)₂PbBr₃)ₙ₋₁PbBr₄, (C₆H₅C₂H₄NH₃)₂(CH(NH₂)₂PbBr₃)ₙ₋₁PbCl₄, (C₁₀H₇CH₂NH₃)₂(CH₃NH₃PbI₂Br)ₙ₋₁PbI₄, (C₁₀H₇CH₂NH₃)₂(CH₃NH₃PbI₂Br)ₙ₋₁PbBr₄ and (C₁₀H₇CH₂NH₃)₂(CH₃NH₃PbI₂Br)ₙ₋₁PbCl₄, where n is the number of layers, and, optionally, n may be in the range of about 2-10. Examples of perovskite light-emitting materials further include Quasi-2D perovskite materials with mixed halides, such as (C₆H₅C₂H₄NH₃)₂(CH(NH₂)₂PbBr₃)ₙ₋₁PbI₃₋ₓClₓ, (C₆H₅C₂H₄NH₃)₂(CH(NH₂)₂PbBr₃)ₙ₋₁PbI₃₋ₓBrₓ, (C₆H₅C₂H₄NH₃)₂(CH(NH₂)₂PbBr₃)ₙ₋₁PbCl₃₋ₓBrₓ, (C₁₀H₇CH₂NH₃ₕ CH₃NH₃PbI₂Br)ₙ₋₁PbI₃₋ₓClₓ, (C₁₀H₇CH₂NH₃)₂(CH₃NH₃PbI₂Br)ₙ₋₁PbI₃₋ₓBrₓ and (C₁₀H₇CH₂NH₃)₂(CH₃NH₃PbI₂Br)ₙ₋₁PbCl₃₋ₓBrₓ, where n is the number of layers, and, optionally, n may be in the range of about 2-10, and x is in the range of 0-3. Examples of perovskite light-emitting materials further include any of the aforementioned examples, where the divalent metal cation lead (Pb⁺) may be replaced with tin (Sn⁺), copper (Cu⁺) or europium (Eu⁺). Examples of perovskite light-emitting materials further include perovskite light-emitting nanocrystals with structures that closely resemble Quasi-2D perovskite materials.

Perovskite light emitting material may comprise organic metal halide perovskite material, such as methylammonium lead iodide (CH₃NH₃PbI₃), methylammonium lead bromide (CH₃NH₃PbBr₃), methylammonium lead chloride (CH₃NH₃PbCl₃), where the materials comprises an organic cation. Perovskite light emitting material may comprise inorganic metal halide perovskite material, such as caesium lead iodide (CsPbI₃), caesium lead bromide (CsPbBr₃) and caesium lead chloride (CsPbCl₃), where the material comprises an inorganic cation. Furthermore, perovskite light emitting material may comprise perovskite light emitting material where there is a combination of organic and inorganic cations. The choice of an organic or inorganic cation may be determined by several factors, including desired emission colour, efficiency of electroluminescence, stability of electroluminescence and ease of processing. Inorganic metal halide perovskite material may be particularly well-suited to perovskite light-emitting materials with a nanocrystal structure, such as those depicted in FIG. **5****,** wherein an inorganic cation may enable a compact and stable perovskite light-emitting nanocrystal structure.

Perovskite light emitting material may be included in the emissive layer **135** in a number of ways. For example, the emissive layer may comprise 2D perovskite light-emitting material, Quasi-2D perovskite light-emitting material or 3D perovskite light-emitting material, or a combination thereof. Optionally, the emissive layer may comprise perovskite light emitting nanocrystals. Optionally, the emissive layer **135** may comprise an ensemble of Quasi-2D perovskite light emitting materials, where Quasi-2D perovskite light emitting materials in the ensemble comprise a different number of layers. An ensemble of Quasi-2D perovskite light emitting materials may be preferred because there may be energy transfer from Quasi-2D perovskite light emitting materials with a smaller number of layers and a larger energy band gap to Quasi-2D perovskite light emitting materials with a larger number of layers and a lower energy band gap. This energy funnel may efficiently confine excitons in a PeLED device, and may improve device performance. Optionally, the emissive layer **135** may comprise perovskite light emitting nanocrystal materials. Perovskite light emitting nanocrystal materials may be preferred because nanocrystal boundaries may be used to confine excitons in a PeLED device, and surface cations may be used to passivate the nanocrystal boundaries. This exciton confinement and surface passivation may improve device performance. Other emissive layer materials and structures may be used.

Organic light emitting materials may be fluorescent or phosphorescent or may emit light through mechanisms such as triplet-triplet annihilation (TTA) or thermally activated delayed fluorescence (TADF). Several examples of fluorescent organic light emitting materials are described in European patent EP 0423283 B1. Several examples of phosphorescent organic light emitting materials are described in United States patents US 6303238 B1 and US 7279704 B2. Several examples of organic light emitting materials that emit through a TADF mechanism are described in Uoyama et al.

Quantum dot light emitting materials may be photoluminescent or electroluminescent. As used herein, the term "quantum dot light emitting materials" refers exclusively to electroluminescent quantum dot light emitting materials. Wherever "quantum dot light emitting materials" are referred to in the text, it should be understood that reference is being made to electroluminescent quantum dot light emitting materials. Several examples of quantum dot light emitting materials are described in Kathirgamanathan et al. (1).

Devices fabricated in accordance with embodiments of the present invention may optionally comprise an electron transport layer **145.** The electron transport layer **145** may include any material capable of transporting electrons. The electron transport layer **145** may be deposited by a solution process or by a vacuum deposition process. The electron transport layer **145** may be doped or undoped. Doping may be used to enhance conductivity.

Examples of undoped electron transport layers are tris(8-hydroxyquinolinato)aluminum (Alq₃), 2,2',2"-(1,3,5-Benzinetriyl)-tris(1-phenyl-1-H-benzimidazole) (TPBi), 2,9-Dimethyl-4,7-diphenyl-1,10-phenanthroline (BCP), zinc oxide (ZnO) and titanium dioxide (TiO₃). One example of a doped electron transport layer is 4,7-diphenyl-1,10-phenanthroline (BPhen) doped with lithium (Li) at a molar ratio of 1:1. One example of a solution-processed electron transport layer is [6,6]-Phenyl C61 butyric acid methyl ester (PCBM). Other electron transport layers and structures may be used. The preceding examples of electron transport materials are all especially well-suited to application in PeLEDs. However, these materials may also be implemented effectively in OLEDs and QLEDs. Substantial similarity between electron transport layer properties required for PeLEDs, OLEDs and QLEDs facilitates the combination of these light emitting devices in a single device, such as a display.

Devices fabricated in accordance with embodiments of the present invention may optionally comprise a cathode **155.** The cathode **155** may comprise any suitable material or combination of materials known to the art, such that the cathode **155** is capable of conducting electronics and injecting them into the layers of the device. Preferred cathode **155** materials include metal oxides, such as indium tin oxide (ITO), indium zinc oxide (IZO) and fluorine tin oxide (FTO), metals, such as calcium (Ca), barium (Ba), magnesium (Mg) and ytterbium (Yb) or a combination thereof. Other preferred cathode **155** materials include metals such as silver (Ag), aluminum (Al), aluminum-neodymium (Al:Nd), gold (Au) and alloys thereof, or a combination thereof. Compound cathodes comprising one or more cathode materials in a single layer may be preferred from some devices. One example of a compound cathode is Mg:Ag. Multilayer cathodes comprising one or more cathode materials in one or more layers may be preferred for some devices. One example of a multilayer cathode is Ba/Al. In a standard device architecture for PeLEDs, OLEDs and QLEDs, the cathode **155** may be sufficiently transparent to create a top-emitting device, where light is emitted from the top of the device. One example of a transparent cathode commonly used in a standard device architecture is a compound layer of Mg:Ag. By using a compound of Mg:Ag, the cathode may be transparent as well as partially reflective. When such a transparent and partially reflective cathode is used in combination with a reflective anode, such as ITO/Ag/ITO, where the Ag thickness is greater than approximately 80nm, this may have the advantage of creating a microcavity effect within the device. A microcavity may provide one or more of the following advantages: an increased total amount of light emitted from device, and therefore higher efficiency and brightness; an increased proportion of light emitted in the forward direction, and therefore increased apparent brightness at normal incidence; and spectral narrowing of the emission spectrum, resulting in light emission with increased colour saturation. The cathode **155** may be opaque and/or reflective. In a standard device architecture for PeLEDs, OLEDs and QLEDs, a reflective cathode **155** may be preferred for some bottom-emitting devices to increase the amount of light emitted through the substrate from the bottom of the device. One example of a reflective cathode commonly used in a standard device architecture is a multilayer cathode of LiF/Al. When such a reflective cathode is used in combination with a transparent and partially reflective anode, such as ITO/Ag/ITO, where the Ag thickness is less than approximately 25nm, this may have the advantage of creating a microcavity effect within the device. A microcavity may provide one or more of the following advantages: an increased total amount of light emitted from device, and therefore higher efficiency and brightness; an increased proportion of light emitted in the forward direction, and therefore increased apparent brightness at normal incidence; and spectral narrowing of the emission spectrum, resulting in light emission with increased colour saturation.

The material and thickness of the cathode **155** may be chosen to obtain desired conductive and optical properties. Where the cathode **155** is transparent, there may be a range of thicknesses for a particular material that is thick enough to provide the desired conductivity, yet thin enough to provide the desired degree of transparency. Other materials and structures may be used. Substantial similarity between cathode properties required for PeLEDs, OLEDs and QLEDs facilitates the combination of these light emitting devices in a single device, such as a display.

Devices fabricated in accordance with embodiments of the present invention may optionally comprise one or more blocking layers. Blocking layers may be used to reduce the number of charge carriers (electrons or holes) and/or excitons exiting the emissive layer. An electron blocking layer **130** may be disposed between the emissive layer **135** and the hole transport layer **125** to block electrons from leaving the emissive layer **135** in the direction of the hole transport layer **125.** Similarly, a hole blocking layer **140** may be disposed between the emissive layer **135** and the electron transport layer **145** to block holes from leaving the emissive layer **135** in the direction of the electron transport layer **145.** Blocking layers may also be used to block excitons from diffusing from the emissive layer. As used herein, and as would be understood by one skilled in the art, the term "blocking layer" means that the layer provides a barrier that significantly inhibits transport of charge carriers and/or excitons, without suggesting that the layer completely blocks the charge carriers and/or excitons. The presence of such a blocking layer in a device may result in substantially higher efficiencies as compared to a similar device lacking a blocking layer. A blocking layer may also be used to confine emission to a desired region of a device. Substantial similarity between blocking layer properties required for PeLEDs, OLEDs and QLEDs facilitates the combination of these light emitting devices in a single device, such as a display.

Devices fabricated in accordance with embodiments of the present invention may optionally comprise one or more injection layers. Generally, injection layers are comprised of one or more materials that may improve the injection of charge carriers from one layer, such as an electrode, into an adjacent layer. Injection layers may also perform a charge transport function.

In device **100,** the hole injection layer **120** may be any layer that improves the injection of holes from the anode **115** into the hole transport layer **125.** Examples of materials that may be used as a hole injection layer are Copper(II)phthalocyanine (CuPc) and 1,4,5,8,9,11-Hexaazatriphenylenehexacarbonitrile (HATCN), which may be vapor deposited, and polymers, such as PEDOT:PSS, which may be deposited from solution. Another example of a material that may be used as a hole injection layer is molybdenum oxide (MoO₃). The preceding examples of hole injection materials are all especially well-suited to application in PeLEDs. However, these materials may also be implemented effectively in OLEDs and QLEDs. Substantial similarity between hole injection layer properties required for PeLEDs, OLEDs and QLEDs facilitates the combination of these light emitting devices in a single device, such as a display.

A hole injection layer (HIL) **120** may comprise a charge carrying component having HOMO energy level that favourably matches, as defined by their herein-described relative IP energies, with the adjacent anode layer on one side of the HIL, and the hole transporting layer on the opposite side of the HIL. The "charge carrying component" is the material responsible for the HOMO energy level that actually transports the holes. This material may be the base material of the HIL, or it may be a dopant. Using a doped HIL allows the dopant to be selected for its electrical properties, and the host to be selected for morphological properties, such as ease of deposition, wetting, flexibility, toughness, and others. Preferred properties of the HIL material are such that holes can be efficiently injected from the anode into the HIL material. The charge carrying component of the HIL **120** preferably has an IP not more than about 0.5 eV greater than the IP of the anode material. Similar conditions apply to any layer into which holes are being injected. HIL materials are further distinguished from conventional hole transporting materials that are typically used in the hole transporting layer of a PeLED, OLED or QLED in that such HIL materials may have a hole conductivity that is substantially less than the hole conductivity of conventional hole transporting materials. The thickness of the HIL **120** of the present invention may be thick enough to planarize the anode and enable efficient hole injection, but thin enough not to hinder transportation of holes. For example, an HIL thickness of as little as 10nm may be acceptable. However, for some devices, an HIL thickness of up to 50nm may be preferred.

In device **100,** the electron injection layer **150** may be any layer that improves the injection of electrons from the cathode **155** into the electron transport layer **145.** Examples of materials that may be used as an electron injection layer are inorganic salts, such as lithium fluoride (LiF), sodium fluoride (NaF), barium fluoride (BaF) and caesium fluoride (CsF), and caesium carbonate (CsCO₃). Other examples of materials that may be used as an electron injection layer are metal oxides, such as zinc oxide (ZnO) and titanium oxide (TiO₂) and metals, such as calcium (Ca), barium (Ba), magnesium (Mg) and ytterbium (Yb). Other materials of combinations of materials may be used for injection layers. Depending on the configuration of a particular device, injection layers may be disposed at location different than those shown in device **100.** The preceding examples of electron injection materials are all especially well-suited to application in PeLEDs. However, these materials may also be implemented effectively in OLEDs and QLEDs. Substantial similarity between electron injection layer properties required for PeLEDs, OLEDs and QLEDs facilitates the combination of these light emitting devices in a single device, such as a display.

Devices fabricated in accordance with embodiments of the present invention may optionally comprise a capping layer **160.** The capping layer **160** may include any material capable of enhancing light extraction from the device. Preferably, the capping layer **160** is disposed over the top electrode in a top-emitting device architecture. Preferably, the capping layer **160** has a refractive index of at least 1.7, and is configured to enhance passage of light from the emissive layer **135** through the top electrode and out of the device, thereby enhancing device efficiency. Examples of materials that may be used for the capping layer **160** are 4,4'-Bis(N-carbazolyl)-1,1'-biphenyl (CBP), Alq₃, and more generally, triamines and arylenediamines. The capping layer **160** may comprise a single layer or multiple layers. Other capping layer materials and structures may be used. Substantial similarity between capping layer properties required for PeLEDs, OLEDs and QLEDs, facilitates the combination of these light emitting devices in a single device, such as a display.

Devices fabricated in accordance with embodiments of the present invention may optionally comprise a barrier layer **165.** One purpose of the barrier layer **165** is to protect device layers from damaging species in the environment, including moisture, vapour and/or gasses. Optionally, the barrier layer **165** may be deposited over, under or next to the substrate, electrode, or any other parts of the device, including an edge. Optionally, the barrier layer **165** may be a bulk material such as glass or metal, and the bulk material may be affixed over, under of next to the substrate, electrode, or any other parts of the device. Optionally, the barrier layer **165** may be deposited onto a film, and the film may be affixed over, under of next to the substrate, electrode, or any other parts of the device. Where the barrier layer **165** is deposited onto a film, preferred film materials comprise glass, plastics, such as polyethylene terephthalate (PET) and polyethylene naphthalate (PEN) and metal foils. Where the barrier layer **165** is a bulk material or deposited onto a film, preferred materials used to affix the film or bulk material to the device include thermal or UV-curable adhesives, hot-melt adhesives and pressure sensitive adhesives.

The barrier layer **165** may be a bulk material or formed by various known deposition techniques, including sputtering, vacuum thermal evaporation, electron-beam deposition and chemical vapour deposition (CVD) techniques, such as plasma-enhanced chemical vapour deposition (PECVD) and atomic layer deposition (ALD). The barrier layer **165** may include compositions having a single phase as well as compositions having multiple phases. Any suitable material or combination of materials may be used for the barrier layer **165.** The barrier layer **165** may incorporate organic or inorganic compounds or both. Preferred inorganic barrier layer materials include aluminum oxides such as Al₂O₃, silicon oxides such SiO₂, silicon nitrides such as SiNₓ and bulk materials such as glasses and metals. Preferred organic barrier layer materials include polymers. The barrier layer **165** may comprise a single layer or multiple layers. Multilayer barriers comprising one or more barrier materials in one or more layers may be preferred for some devices. One preferred example of a multilayer barrier is a barrier comprising alternating layers of SiNₓ and a polymer, such as in the multilayer barrier SiNₓ/polymer/SiNₓ. Substantial similarity between barrier layer properties required for PeLEDs, OLEDs and QLEDs facilitates the combination of these light emitting devices in a single device, such as a display.

Unless otherwise specified, any one of the layers of the various embodiments may be deposited by any suitable method. Methods include vacuum thermal evaporation, sputtering, electron beam physical vapour deposition, organic vapor phase deposition and organic vapour jet printing. Other suitable methods include spincoating and other solution-based processes. Substantially similar processes can be used to deposit PeLEDs, OLEDs and QLEDs, which facilitates the combination of these light emitting devices in a single device, such as a display.

Devices fabricated in accordance with embodiments of the invention may be incorporated into a wide range of consumer products. Optionally, devices may be used in displays for televisions, computer monitors, tablets, laptop computers, smart phones, cell phones, digital cameras, video recorders, smartwatches, fitness trackers, personal digital assistants, vehicle displays and other electronic devices. Optionally, devices may be used for micro-displays or heads-up displays. Optionally, devices may be used in light sources for interior or exterior illumination and/or signaling, in smart packaging or in billboards.

Optionally, various control mechanisms may be used to control PeLED, OLED and QLED devices fabricated in accordance with the present invention, including passive matrix and active matrix address schemes.

The materials and structures described herein may have applications in devices other than light emitting devices. For example, other optoelectronic devices such as solar cells, photodetectors, transistors or lasers may employ the materials and structures.

Layers, materials, regions and devices may be described herein in reference to the colour of light they emit. As used herein, a "red" layer, material, region or device, refers to one that emits light that has an emission spectrum with a peak wavelength in the range of about 580-780nm; a "green" layer, material, region or device, refers to one that emits light that has an emission spectrum with a peak wavelength in the range of about 500-580nm; a "blue" layer, material, region or device, refers to one that emits light that has an emission spectrum with a peak wavelength in the range of about 380-500nm; a "light blue" layer, material, region or device, refers to one that emits light that has an emission spectrum with a peak wavelength in the range of about 460-500nm; and a "yellow" layer, material, region or device, refers to one that emits light that has an emission spectrum with a peak wavelength in the range of about 540-600nm. Preferred ranges include a peak wavelength in the range of about 600-640nm for red, about 510-550nm for green, about 440-465nm for blue, about 465-480nm for light blue, and about 550-580nm for yellow.

Similarly, any reference to a colour altering layer refers to a layer that converts or modifies another colour of light to light having a wavelength as specified for that colour. For example, a "red" color filter refers to a filter that results in light having an emission spectrum with a peak wavelength in the range of about 580-780nm. In general, there are two classes of colour altering layers: colour filters that modify a spectrum by removing unwanted wavelengths of light, and colour changing layers that convert photons of higher energy to photons of lower energy.

Display technology is rapidly evolving, with recent innovations enabling thinner and lighter displays with higher resolution, improved frame rate and enhanced contrast ratio. However, one area where significant improvement is still required is colour gamut. Digital displays are currently incapable of producing many of the colours the average person experiences in day-to-day life. To unify and guide the industry towards improved colour gamut, two industry standards have been defined, DCI-P3 and Rec. 2020, with DCI-P3 often seen as a stepping stone towards Rec. 2020.

DCI-P3 was defined by the Digital Cinema Initiatives (DCI) organization and published by the Society of Motion Picture and Television Engineers (SMPTE). Rec. 2020 (more formally known as ITU-R Recommendation BT. 2020) was developed by the International Telecommunication Union to set targets, including improved colour gamut, for various aspects of ultra-high-definition televisions.

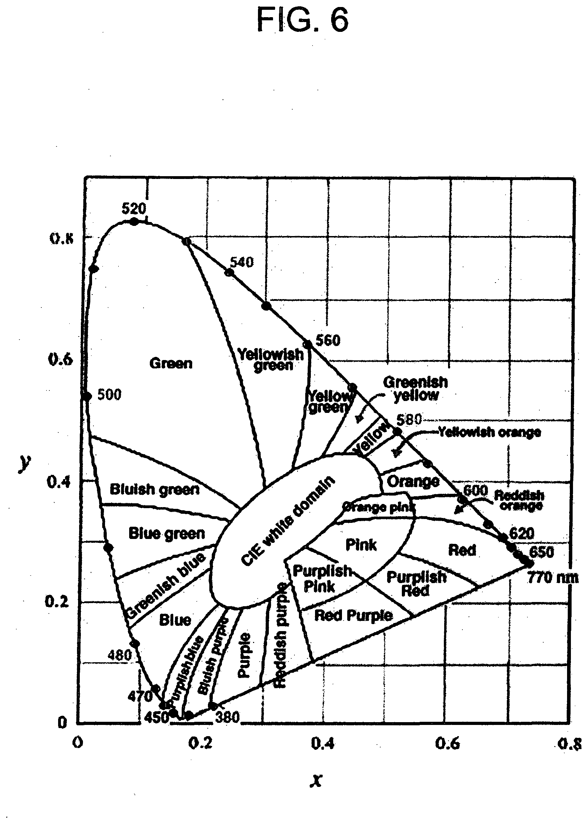

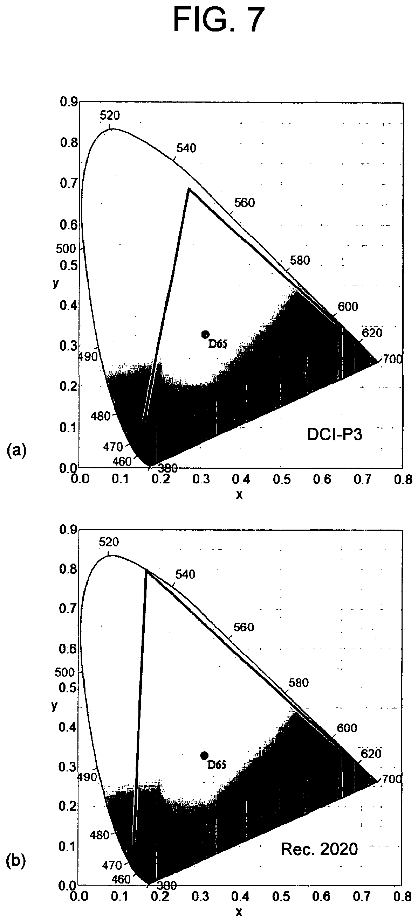

The CIE 1931 (x, y) chromaticity diagram was created by the Commission Internationale de l'Eclairage (CIE) in 1931 to define all colour sensations that an average person can experience. Mathematical relationships describe the location of each colour within the chromaticity diagram. The CIE 1931 (x, y) chromaticity diagram may be used to quantify the colour gamut of displays. The white point (D65) is at the centre, while colours become increasingly saturated (deeper) towards the extremities of the diagram. FIG. **6** shows the CIE 1931 (x, y) chromaticity diagram with labels added to different locations on the diagram to enable a general understanding of distribution of colour within the colour space. FIG. **7** shows (a) DCI-P3 and (b) Rec. 2020 colour spaces superimposed on the CIE 1931 (x, y) chromaticity diagram. The tips of the triangles are primary colours for DCI-P3 and Rec. 2020, respectively, while areas within the triangles are all colours that can be reproduced by combining these primary colours. For a display to meet DCI-P3 colour gamut specifications, the red, green and blue sub-pixels of the display must emit light at least as deep in colour as the DCI-P3 primary colours. For a display to meet Rec. 2020 colour gamut specifications, the red, green and blue sub-pixels of the display must emit light at least as deep in colour as the Rec 2020 primary colours. Primary colours for Rec. 2020 are significantly deeper than for DCI-P3, and therefore achievement of the Rec. 2020 standard for colour gamut is seen as a greater technical challenge than achieving the DCI-P3 standard.

OLED displays can successfully render the DCI-P3 colour gamut. For example, smartphones with OLED displays such as the iPhone X (Apple), Galaxy S9 (Samsung) and OnePlus 5 (OnePlus) can all render the DCI-P3 gamut. Commercial liquid crystal displays (LCDs) can also successfully render the DCI-P3 colour gamut. For example, LCDs in the Surface Studio (Microsoft), Mac Book Pro and iMac Pro (both Apple) can all render the DCI-P3 gamut. In addition, electroluminescent and photoluminescent quantum dot technology has also been used to demonstrate electroluminescent and photoluminescent QLED displays with wide colour gamut. However, until now, no display has been demonstrated that can render the Rec. 2020 colour gamut.

Here we disclose a novel pixel arrangement for application in a display. In various embodiments, when implemented in a display, the pixel arrangement can enable the display to render the DCI-P3 colour gamut. In various embodiments, when implemented in a display, the pixel arrangement can enable the display to render the Rec. 2020 colour gamut.

The novel pixel arrangement comprises a plurality of pixels, each pixel comprising a first sub-pixel configured to emit a first colour of light, the first sub-pixel comprising a PeLED; a second sub-pixel configured to emit a second colour of light that is different from the first colour of light; and a third sub-pixel configured to emit a third colour of light that is different from the first and second colour of light, wherein the second sub-pixel comprises a PeLED, an OLED or a QLED, and the third sub-pixel comprises a PeLED, an OLED or a QLED.

Until now, no display has been demonstrated that comprises a PeLED. We demonstrate that by including one or more PeLEDs within a pixel arrangement for application in a display, the colour gamut of the display can be extended. We further demonstrate that colour gamut can be further extended by combining PeLEDs with OLED and/or QLEDs in a pixel arrangement.

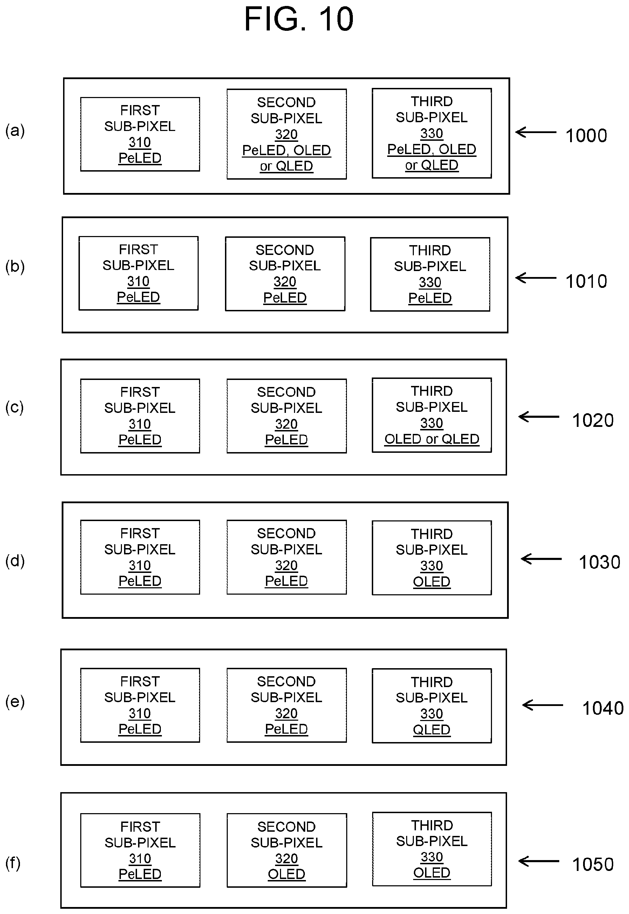

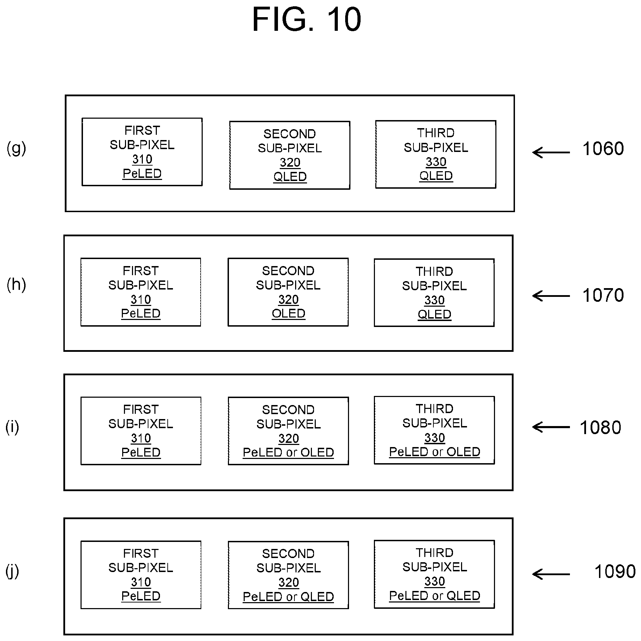

A pixel arrangement for application in a display is provided herein. FIG. **10** depicts various configurations of the pixel arrangement that comprise various combinations of light emitting diodes. The configurations in Fig. 10a to 10d, 10f, 10h and 10i do not form part of the claimed invention.

In each configuration, the pixel arrangement comprises a plurality of pixels, each pixel comprising a first sub-pixel 310 configured to emit a first colour of light, the first sub-pixel **310** comprising a PeLED; a second sub-pixel **320** configured to emit a second colour of light that is different from the first colour of light; and a third sub-pixel **330** configured to emit a third colour of light that is different from the first and second colour of light, wherein the second sub-pixel **320** comprises a PeLED, an OLED or a QLED, and the third sub-pixel **330** comprises a PeLED, an OLED or a QLED. FIG. **10a** depicts pixel arrangement **1000,** where the first sub-pixel **310** comprises a PeLED, the second sub-pixel **320** comprises a PeLED, an OLED or a QLED, and the third sub-pixel **330** comprises a PeLED, an OLED or a QLED. In one embodiment of pixel arrangement **1000,** one of the sub-pixels emits red light, one of the sub-pixels emits green light, and one of the sub-pixels emits blue light. Such a pixel arrangement may be advantageous because the combination of different light emitting diodes may enable the optimum type of light emitting diode to be selected for each sub-pixel within the pixel arrangement, thereby enhancing performance beyond that which could be achieved by a pixel arrangement comprising a single type of light emitting diode, such as only PeLEDs, only OLEDs or only QLEDs.

In one embodiment of the pixel arrangement (not forming part of the claimed invention), the first sub-pixel **310** comprises a PeLED, the second sub-pixel **320** comprises a PeLED and the third sub-pixel **330** comprises a PeLED. **FIG. 10b** depicts pixel arrangement **1010,** where the first sub-pixel **310** comprises a PeLED, the second sub-pixel **320** comprises a PeLED, and the third sub-pixel **330** comprises a PeLED. In one embodiment of pixel arrangement **1010,** one of the sub-pixels emits red light, one of the sub-pixels emits green light, and one of the sub-pixels emits blue light. Such a pixel arrangement may be advantageous in that the manufacturing process of a display comprising such a pixel arrangement may be simplified if PeLEDs are implemented in all sub-pixels of the display.

In one embodiment of the pixel arrangement (not forming part of the claimed invention), the first sub-pixel **310** comprises a PeLED, and at least one of the second sub-pixel **320** and the third sub-pixel **330** comprises an OLED or a QLED. Such a pixel arrangement may be advantageous because the combination of different light emitting diodes may enable the optimum type of light emitting diode to be selected for each sub-pixel within the pixel arrangement, thereby enhancing performance beyond that which could be achieved from a pixel arrangement comprising a single type of light emitting diode, such as only PeLEDs, only OLEDs or only QLEDs.

In one embodiment of the pixel arrangement (not forming part of the claimed invention), the first sub-pixel **310** comprises a PeLED, the second sub-pixel **320** comprises a PeLED and the third sub-pixel **330** comprises an OLED or a QLED. FIG. **10c** depicts pixel arrangement **1020,** where the first sub-pixel **310** comprises a PeLED, the second sub-pixel **320** comprises a PeLED, and the third sub-pixel **330** comprises an OLED or a QLED. In one embodiment of pixel arrangement **1020,** one of the sub-pixels emits red light, one of the sub-pixels emits green light, and one of the sub-pixels emits blue light. Such a pixel arrangement may be advantageous because a PeLED device architecture may be preferred for the first and second sub-pixels of a display, but the performance of the display may be enhanced if an OLED or QLED device architecture is used for the third sub-pixel of the display. For example, the colour gamut, electroluminescence efficiency and/or electroluminescence stability of the display may be enhanced.

In one embodiment of the pixel arrangement (not forming part of the claimed invention), the first sub-pixel **310** comprises a PeLED, the second sub-pixel **320** comprises a PeLED or an OLED and the third sub-pixel **330** comprises a PeLED or an OLED, wherein at least one of the second sub-pixel and the third sub-pixel comprises an OLED. FIG. **10i** depicts pixel arrangement **1080,** where the first sub-pixel **310** comprises a PeLED, the second sub-pixel **320** comprises a PeLED or an OLED, and the third sub-pixel **330** comprises a PeLED or an OLED, wherein at least one of the second sub-pixel and the third sub-pixel comprises an OLED. In one embodiment of pixel arrangement **1080,** one of the sub-pixels emits red light, one of the sub-pixels emits green light, and one of the sub-pixels emits blue light.

Such a pixel arrangement may be advantageous because a PeLED device architecture may be preferred for the first sub-pixel of a display, but the performance of the display may be enhanced if an OLED device architecture is used for the second and/or third sub-pixel of the display. For example, the colour gamut, electroluminescence efficiency and/or electroluminescence stability of the display may be enhanced. In one embodiment (not forming part of the claimed invention), the first sub-pixel may comprise a PeLED that emits green light, the second sub-pixel may comprise an OLED that emits red light, and the third sub-pixel may comprise an OLED that emits blue light. Such a pixel arrangement may enhance the colour gamut of a display. Combination of PeLED device architectures with OLED device architectures within the pixel arrangement of a display may be particularly advantageous because advanced OLED performance already available in commercial products may be complemented and enhanced where required by PeLED device performance.

In one embodiment of the pixel arrangement (not forming part of the claimed invention), the first sub-pixel **310** comprises a PeLED, the second sub-pixel **320** comprises a PeLED and the third sub-pixel **330** comprises an OLED. FIG. **10d** depicts a pixel arrangement **1030,** where the first sub-pixel **310** comprises a PeLED, the second sub-pixel **320** comprises a PeLED, and the third sub-pixel **330** comprises an OLED. In one embodiment of pixel arrangement **1030,** one of the sub-pixels emits red light, one of the sub-pixels emits green light, and one of the sub-pixels emits blue light. Such a pixel arrangement may be advantageous because a PeLED device architecture may be preferred for the first and second sub-pixels of a display, but the performance of the display may be enhanced if an OLED device architecture is used for the third sub-pixel of the display. For example, the colour gamut, electroluminescence efficiency and/or electroluminescence stability of the display may be enhanced. In one embodiment, the first sub-pixel may comprise a PeLED that emits red light, the second sub-pixel may comprises a PeLED that emits green light, and the third sub-pixel may comprise an OLED that emits blue light. Such a pixel arrangement may enhance the colour gamut of a display.

In one embodiment of the pixel arrangement, the first sub-pixel **310** comprises a PeLED, the second sub-pixel **320** comprises a PeLED or a QLED and the third sub-pixel **330** comprises a PeLED or a QLED, wherein at least one of the second sub-pixel and the third sub-pixel comprises a QLED. FIG. **10j** depicts pixel arrangement **1090,** where the first sub-pixel **310** comprises a PeLED, the second sub-pixel **320** comprises a PeLED or a QLED, and the third sub-pixel **330** comprises a PeLED or a QLED, wherein at least one of the second sub-pixel and the third sub-pixel comprises a QLED. In one embodiment of pixel arrangement **1090,** one of the sub-pixels emits red light, one of the sub-pixels emits green light, and one of the sub-pixels emits blue light.

Such a pixel arrangement may be advantageous because a PeLED device architecture may be preferred for the first sub-pixel of a display, but the performance of the display may be enhanced if a QLED device architecture is used for the second and/or third sub-pixel of the display. For example, the colour gamut, electroluminescence efficiency and/or electroluminescence stability of the display may be enhanced. In one embodiment, the first sub-pixel may comprise a PeLED that emits green light, the second sub-pixel may comprise a QLED that emits red light, and the third sub-pixel may comprise a PeLED that emits blue light. Such a pixel arrangement may enhance the colour gamut of a display. Combination of PeLED device architectures with QLED device architectures within the pixel arrangement of a display may be particularly advantageous because the similarity of structure of perovskite light-emitting materials and quantum dot light-emitting materials may allow these device architectures to be manufactured together with little or no added complexity. For example, in the case of solution-process manufacturing, common solvents may be used to process perovskite light-emitting materials and quantum dot light-emitting materials.

In one embodiment of the pixel arrangement, the first sub-pixel **310** comprises a PeLED, the second sub-pixel **320** comprises a PeLED and the third sub-pixel **330** comprises a QLED. FIG. **10e** depicts pixel arrangement **1040,** where the first sub-pixel **310** comprises a PeLED, the second sub-pixel **320** comprises a PeLED, and the third sub-pixel **330** comprises a QLED. In one embodiment of pixel arrangement **1040,** one of the sub-pixels emits red light, one of the sub-pixels emits green light, and one of the sub-pixels emits blue light. Such a pixel arrangement may be advantageous because a PeLED device architecture may be preferred for the first and second sub-pixels of a display, but the performance of the display may be enhanced if a QLED device architecture is used for the third sub-pixel of the display. For example, the colour gamut, electroluminescence efficiency and/or electroluminescence stability of the display may be enhanced. In one embodiment, the first sub-pixel may comprise a PeLED that emits green light, the second sub-pixel may comprises a PeLED that emits blue light, and the third sub-pixel may comprise a QLED that emits red light. Such a pixel arrangement may enhance the colour gamut of a display.

In one embodiment of the pixel arrangement (not forming part of the claimed invention), the first sub-pixel **310** comprises a PeLED, the second sub-pixel **320** comprises an OLED and the third sub-pixel **330** comprises an OLED. FIG. **10f** depicts pixel arrangement **1050,** where the first sub-pixel **310** comprises a PeLED, the second sub-pixel **320** comprises an OLED, and the third sub-pixel **330** comprises an OLED. In one embodiment of pixel arrangement **1050,** one of the sub-pixels emits red light, one of the sub-pixels emits green light, and one of the sub-pixels emits blue light. Such a pixel arrangement may be advantageous because a PeLED device architecture may be preferred for the first sub-pixel of a display, but the performance of the display may be enhanced if an OLED device architecture is used for the second and third sub-pixels of the display. For example, the colour gamut, electroluminescence efficiency and/or electroluminescence stability of the display may be enhanced. In one embodiment, the first sub-pixel may comprise a PeLED that emits green light, the second sub-pixel may comprises an OLED that emits red light, and the third sub-pixel may comprise an OLED that emits blue light. Such a pixel arrangement may enhance the colour gamut of a display.

In one embodiment of the pixel arrangement, the first sub-pixel **310** comprises a PeLED, the second sub-pixel **320** comprises a QLED and the third sub-pixel **330** comprises a QLED. FIG. **10g** depicts pixel arrangement **1060,** where the first sub-pixel **310** comprises a PeLED, the second sub-pixel **320** comprises a QLED, and the third sub-pixel **330** comprises a QLED. In one embodiment of pixel arrangement **1060,** one of the sub-pixels emits red light, one of the sub-pixels emits green light, and one of the sub-pixels emits blue light. Such a pixel arrangement may be advantageous because a PeLED device architecture may be preferred for the first sub-pixel of a display, but the performance of the display may be enhanced if a QLED device architecture is used for the second and third sub-pixels of the display. For example, the colour gamut, electroluminescence efficiency and/or electroluminescence stability of the display may be enhanced. In one embodiment, the first sub-pixel may comprise a PeLED that emits blue light, the second sub-pixel may comprises a QLED that emits red light, and the third sub-pixel may comprise a QLED that emits green light. Such a pixel arrangement may enhance the colour gamut of a display.

In one embodiment of the pixel arrangement (not forming part of the claimed invention), the first sub-pixel **310** comprises a PeLED, the second sub-pixel **320** comprises an OLED and the third sub-pixel 330 comprises a QLED. FIG. **10h** depicts pixel arrangement **1070,** where the first sub-pixel **310** comprises a PeLED, the second sub-pixel **320** comprises an OLED, and the third sub-pixel **330** comprises a QLED. In one embodiment of pixel arrangement **1070,** one of the sub-pixels emits red light, one of the sub-pixels emits green light, and one of the sub-pixels emits blue light. Such a pixel arrangement may be advantageous because a PeLED device architecture may be preferred for the first sub-pixel of a display, but the performance of the display may be enhanced if an OLED device architecture is used for the second sub-pixel of the display and a QLED device architecture is used for the third sub-pixel of the display. For example, the colour gamut, electroluminescence efficiency and/or electroluminescence stability of the display may be enhanced. In one embodiment, the first sub-pixel may comprise a PeLED that emits green light, the second sub-pixel may comprises an OLED that emits blue light, and the third sub-pixel may comprise a QLED that emits red light. Such a pixel arrangement may enhance the colour gamut of a display.

The pixel arrangements **1000, 1010, 1020, 1030, 1040, 1050, 1060, 1070, 1080** and **1090** may be of advantage in that by including at least one PeLED in at least one sub-pixel, the colour gamut of the pixel arrangement may be extended. The pixel arrangements **1000, 1020, 1030, 1040, 1050, 1060, 1070, 1080** and **1090** may be of further advantage in that one or more PeLEDs may be combined with one or more OLEDs and/or QLEDs to further extend the colour gamut of the pixel arrangement. When such pixel arrangements are implemented in a display, the colour gamut of the display may be extended. Such a combination of PeLED, OLED and/or QLED devices may be demonstrated in practice because substantial similarity between device architectures and processing techniques facilitates their combination within a pixel arrangement. Combination of different light emitting diodes enables the optimum type of light emitting diode to be selected for each sub-pixel within the pixel arrangement, thereby enhancing performance beyond that which could be expected from a pixel arrangement comprising a single type of light emitting diode, such as only PeLEDs, only OLEDs, or only QLEDs. Enhancement in performance may be through extended colour gamut, increased efficiency, increased brightness, extended operation lifetime, reduced voltage, reduced costs or other enhancements.

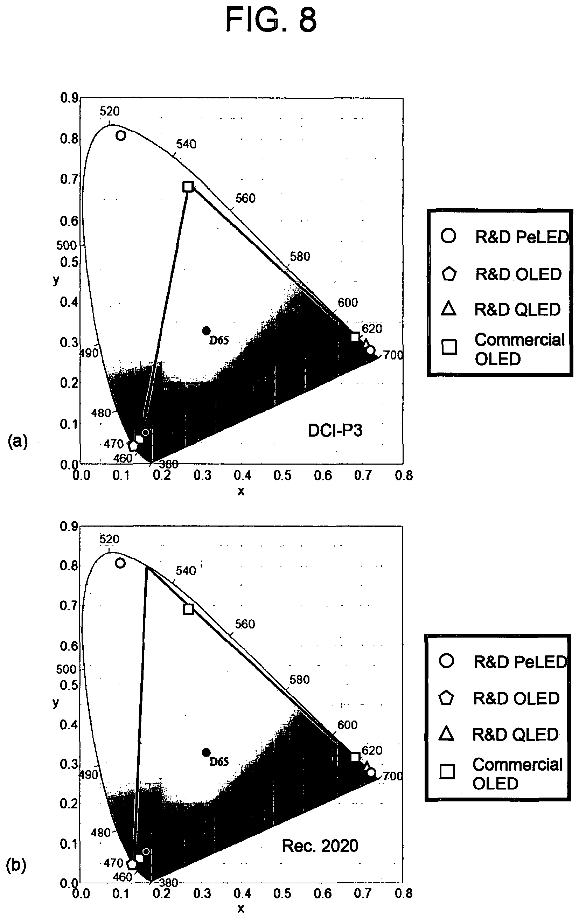

One or more advantages of including at least one PeLED in at least one sub-pixel of a pixel arrangement, and/or combining one or more PeLEDs with one or more OLEDs and/or QLEDs in a pixel arrangement, may be demonstrated using the data shown in Table **1** and FIG. **8****.** Table **1** shows CIE 1931 (x, y) colour coordinates for red, green and blue PeLED, OLED and QLED devices. Also included in Table **1** are CIE 1931 (x, y) colour coordinates for DCI-P3 and Rec. 2020 colour gamut standards. Generally, for red light, a higher CIE x value corresponds to deeper emission colour, for green light, a higher CIE y value corresponds to deeper emission colour, and for blue light, a lower CIE y value corresponds to deeper emission colour. This can be understood with reference FIG. **8****,** which includes markers for the red, green and blue R&D PeLED (circles), R&D OLED (pentagon), R&D QLED (triangles) and Commercial OLED (squares) device data in Table **1,** as well as markers for the primary colours of the DCI-P3 colour gamut in FIG. **8a** and for the Rec. 2020 colour gamut in FIG. **8b****.**

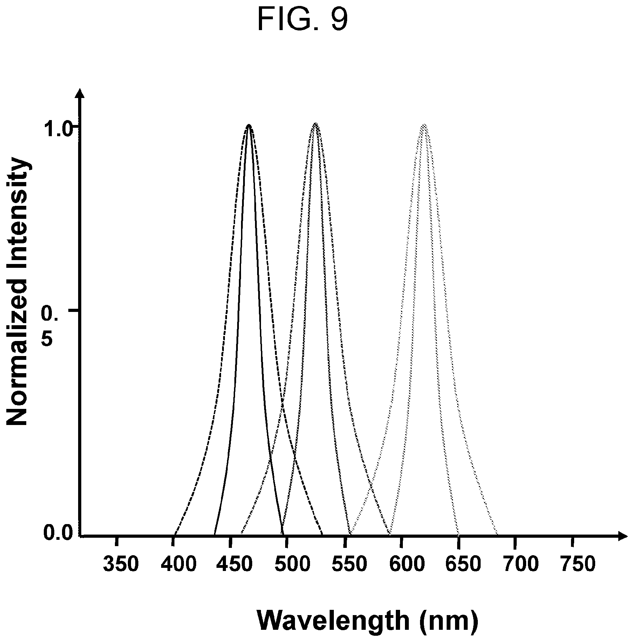

FIG. **9** depicts exemplary electroluminescence emission spectra for red, green and blue PeLEDs, OLEDs and QLEDs. The red, green and blue spectra depicted using dashed lines correspond to spectra for Commercial OLED devices, such as those in the Apple iPhone X, which may be used to render the DCI-P3 colour gamut. The red spectrum depicted using a solid line corresponds to the spectrum for a red light emitting R&D QLED device. The green spectrum depicted using a solid line corresponds to the spectrum for a green light emitting R&D PeLED device. The blue spectrum depicted using a solid line corresponds to the spectrum for a blue light emitting R&D OLED device. It can be seen from FIG. **9** that as an emission spectra narrows, emission colour becomes more saturated. Electroluminescence spectra depicted using solid lines in FIG. **9** correspond to light emitting devices that may be used to render the Rec. 2020 colour gamut.

**Table 1: CIE 1931 (x, y) colour coordinates for exemplary PeLED, OLED and QLED devices. Also included are colour coordinates for DCI-P3 and Rec. 2020 colour gamut standards.**

| | **Red** | | **Green** | | **Blue** | |
|---|---|---|---|---|---|---|
| | **CIE x** | **CIE y** | **CIE x** | **CIE y** | **CIE x** | **CIE y** |
| **DCI-P3** | 0.680 | 0.320 | 0.265 | 0.690 | 0.150 | 0.060 |
| **Rec. 2020** | 0.708 | 0.292 | 0.170 | 0.797 | 0.131 | 0.046 |
| **Commercial OLED** | 0.680 | 0.320 | 0.265 | 0.690 | 0.150 | 0.060 |
| **R&D PeLED** | 0.720 | 0.280 | 0.100 | 0.810 | 0.166 | 0.079 |
| **R&D OLED** | --- | --- | --- | --- | 0.146 | 0.045 |
| **R&D QLED** | 0.712 | 0.288 | --- | --- | --- | --- |

The CIE 1931 (x, y) colour coordinate data reported for red, green and blue PeLED, OLED and QLED devices in Table **1** are exemplary. Commercial OLED data are taken from the Apple iPhone X, which fully supports the DCI-P3 colour gamut. This data set is available from Raymond Soneira at DisplayMate Technologies Corporation (Soneira et al.). Data for R&D PeLED, R&D OLED and R&D QLED devices are taken from a selection of peer-reviewed scientific journals: Red R&D PeLED data are taken from Wang et al. (1). Red R&D QLED data are taken from Kathirgamanathan et al. (2). Green R&D PeLED data are taken from Hirose et al. Blue R&D PeLED data are taken from Kumar et al. Blue R&D OLED data is taken from Takita et al. Data from these sources is used by way of example, and should be considered non-limiting. Data from other peer-reviewed scientific journals, simulated data and/or experimental data collected from laboratory devices may also be used to demonstrate the aforementioned advantages of the claimed pixel arrangement.

As can be seen from Table **1** and FIG. **8a****,** existing OLED technology can already be used to demonstrate a commercial display that can render the DCI-P3 colour gamut, as is exemplified by the Apple iPhone X. However, as can be seen from FIG. **8b****,** existing OLED technology alone cannot be used to demonstrate a display that can render the Rec. 2020 colour gamut.

Table **1** and FIG. **8b** show that one path to demonstrating a display that can render the Rec. 2020 colour gamut is to include one or more PeLED devices in one or more sub-pixels of a pixel arrangement for application in a display. In one embodiment, one of the first, second and third sub-pixels emits red light; one of the first, second and third sub-pixels emits green light; and one of the first, second and third sub-pixels emits blue light.

Optionally, by including a PeLED device in a sub-pixel of the pixel arrangement, the sub-pixel may emit green light with CIE 1931 (x, y) = (0.100, 0.810), which as can be seen from FIG. **8b****,** is more saturated than the green primary colour for the Rec. 2020 standard, which has CIE 1931 (x, y) = (0.170, 0.797). Optionally, by including a PeLED device in a sub-pixel of the pixel arrangement, the sub-pixel may emit red light with CIE 1931 (x, y) = (0.720, 0.280), which as can be seen from FIG. **8b****,** is more saturated than the red primary color for the Rec. 2020 standard, which has CIE 1931 (x, y) = (0.708, 0.292). This demonstrates how one or more PeLED devices may be used to extend the colour gamut of a pixel arrangement and a display into which the pixel arrangement is incorporated. Optionally, by including a PeLED device in a sub-pixel of the pixel arrangement, the sub-pixel may emit blue light with CIE 1931 (x, y) = (0.166, 0.079). This is not as saturated as the blue primary colour for the Rec. 2020 standard, which has CIE 1931 (x, y) = (0.131, 0.046).

However, colour gamut is only one metric by which the performance of a display may be measured. Other performance parameters, such as efficiency, brightness, operational lifetime, voltage, process conditions and cost must also be considered in design of a pixel arrangement. It may be advantageous under some circumstances to combine one or more sub-pixels comprising one or more PeLEDs with one or more sub-pixels comprising one or more OLEDs and/or one or more QLEDs in a pixel arrangement.

Optionally, by including a QLED device in a sub-pixel of the pixel arrangement, the sub-pixel may emit red light with CIE 1931 (x, y) = (0.712, 0.288), which as can be seen from FIG. **8b****,** is more saturated than the red primary color for the Rec. 2020 standard, which has CIE 1931 (x, y) = (0.708, 0.292). As described herein, the colour saturation of red light emission from such an exemplary sub-pixel comprising a QLED is slightly lower than that of red light emission from an exemplary sub-pixel comprising a PeLED. However, under some circumstances, the QLED device may provide the pixel arrangement with one or more advantages, such as improved efficiency, higher brightness, improved operational lifetime, lower voltage and/or reduced cost, and may therefore be preferred for implementation in the pixel arrangement.

Optionally, by including an OLED device in a sub-pixel of the pixel arrangement, the sub-pixel may emit blue light with CIE 1931 (x, y) = (0.146, 0.045), which as can be seen from FIG. **8b****,** is more saturated than the blue primary color for the Rec. 2020 standard, which has CIE 1931 (x, y) = (0.131, 0.046). This is also more saturated than the blue light emitted by the blue R&D PeLED device listed in Table **1.**

Optionally, by combining one or more sub-pixels comprising one or more PeLEDs with one or more sub-pixels comprising one or more OLEDs and/or one or more QLEDs, a pixel arrangement that may render the DCI-P3 colour gamut may be demonstrated. In one embodiment, one of the first, second and third sub-pixels may emit red light with CIE 1931 x coordinate greater than or equal to 0.680; one of the first, second and third sub-pixels may emit green light with CIE 1931 y coordinate greater than or equal to 0.690; and one of the first, second and third sub-pixels may emit blue light with CIE 1931 y coordinate less than or equal to 0.060. Such a pixel arrangement may be of advantage in that it fulfills colour gamut requirements of the DCI-P3 display standard. Such a pixel arrangement may be of advantage in that when implemented in a display, the display may render a broader range of colours experienced in everyday life, thereby improving functionality and user experience.

Optionally, by combining one or more sub-pixels comprising one or more PeLEDs with one or more sub-pixels comprising one or more OLEDs and/or one or more QLEDs, a pixel arrangement that may render the Rec. 2020 colour gamut may be demonstrated. In one embodiment, one of the first, second and third sub-pixels may emit red light with CIE 1931 x coordinate greater than or equal to 0.708; one of the first, second and third sub-pixels may emit green light with CIE 1931 y coordinate greater than or equal to 0.797; and one of the first, second and third sub-pixels may emit blue light with CIE 1931 y coordinate less than or equal to 0.046. Such a pixel arrangement may be of advantage in that it fulfills colour gamut requirements of the Rec. 2020 display standard. Such a pixel arrangement may be of advantage in that when implemented in a display, the display may render a broader range of colours experienced in everyday life, thereby improving functionality and user experience.

Optionally, the pixel arrangement may comprise a plurality of pixels, each pixel comprising a first sub-pixel configured to emit red light, the first sub-pixel comprising a PeLED, a second sub-pixel configured to emit green light, the second sub-pixel comprising a PeLED, and a third sub-pixel configured to emit blue light, the third sub-pixel comprising an OLED.

Optionally, the pixel arrangement may comprise a plurality of pixels, each pixel comprising a first sub-pixel configured to emit red light, the first sub-pixel comprising a QLED, a second sub-pixel configured to emit green light, the second sub-pixel comprising a PeLED, and a third sub-pixel configured to emit blue light, the third sub-pixel comprising an OLED.

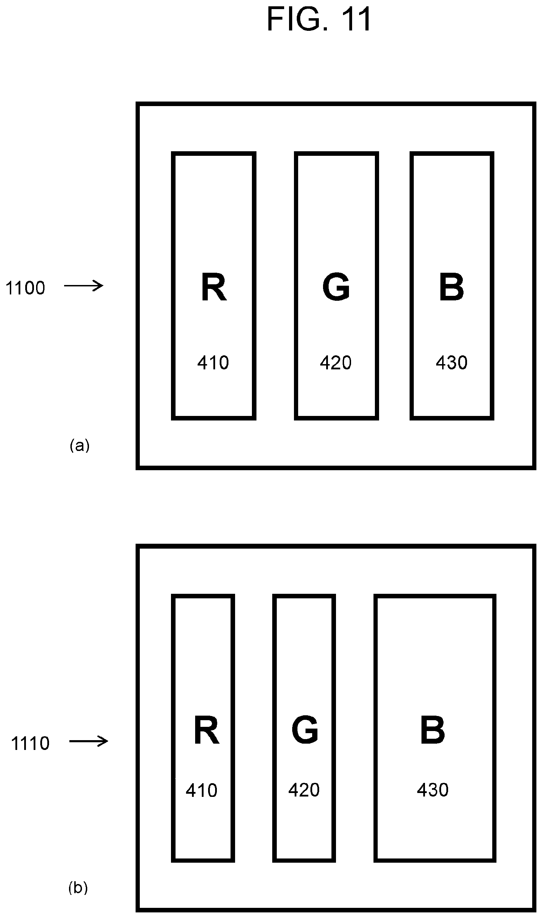

In one embodiment, the first, second and third sub-pixels of the pixel arrangement may have the same surface area. FIG. **11** depicts various configurations of sub-pixel layout and size for a pixel arrangement having three sub-pixels. FIG. **11a** depicts pixel arrangement **1100,** which is an example of a pixel arrangement wherein the first sub-pixel **410,** the second sub-pixel **420** and the third sub-pixel **430** have the same surface area. Optionally, the first sub-pixel **410** may be configured to emit red light, the second sub-pixel **420** may be configured to emit green light, and the third sub-pixel **430** may be configured to emit blue light. Such a pixel arrangement may be of advantage in that the manufacturing process may be simplified by each of the sub-pixels having the same surface area.

In one embodiment, at least one of the first, second and third sub-pixels has a surface area different from another of the first, second and third sub-pixels. FIG. **11b** depicts pixel arrangement **1110,** which is an example of a pixel arrangement wherein the first sub-pixel **410** and the second sub-pixel **420** have a different surface area to the third sub-pixel **430.** Optionally, the first sub-pixel **410** may be configured to emit red light, the second sub-pixel **420** may be configured to emit green light, and the third sub-pixel **430** may be configured to emit blue light.

Optionally, and as depicted in pixel arrangement **1110,** the surface area of the sub-pixel configured to emit blue light (sub pixel **430** in pixel arrangement **1110)** may be substantially greater than the surface area of the sub-pixel configured to emit red light (sub pixel **410** in pixel arrangement **1110).** Optionally, and as depicted in pixel arrangement **1110,** the surface area of the sub-pixel configured to emit blue light (sub pixel **430** in pixel arrangement **1110)** may be substantially greater than the surface area of the sub-pixel configured to emit green light (sub pixel **420** in pixel arrangement **1110).**

Such a pixel arrangement may be of advantage in that it may extend the operational lifetime of a display into which it is incorporated. One reason for this may be that the light-emitting materials used in the sub-pixel that emits blue light may have shorter operational lifetime compared to the light-emitting materials used in the sub-pixels that emit red and green light. This effect may be seen in PeLED, OLED and QLED devices, and may be a result of the higher energy associated with blue light compared to red and green light. The higher energy associated with blue light means that the energy band gap between HOMO and LUMO levels is necessarily greater, which may result in the exciton state being more difficult to stabilize, and therefore shorter operational lifetime may result. By increasing the surface area of the sub-pixel that emits blue light, it may be possible to generate the same total light output from the sub-pixel at a lower luminance. For example, if the surface area of the sub-pixel is increased by a factor of two, the luminance may be reduced by a factor of two, and the same total light output may still be achieved. It is well understood in the art that by reducing luminance, operation lifetime for PeLED, OLED and QLED devices may be extended. Therefore, by increasing the surface area of the sub-pixel that emits blue light to be greater than the surface area of each of the sub-pixels that emit red and green light, the operational lifetime of the red, green and blue sub-pixels may be more evenly balanced, and the operational lifetime of a display into which such a pixel arrangement is incorporated may be extended.

In one embodiment, the pixel arrangement may further comprise a fourth sub-pixel configured to emit a fourth colour of light that is different from the first, second and third colour of light, the fourth sub-pixel comprising a PeLED, an OLED or a QLED. Such a pixel arrangement may be of advantage in that a fourth sub-pixel may broaden the colour gamut of a display into which it is incorporated.

In one embodiment, the first, second, third and fourth sub-pixels of the pixel arrangement may have the same surface area. In one embodiment, at least one of the first, second, third and fourth sub-pixels has a surface area different from another of the first, second, third and fourth sub-pixels.

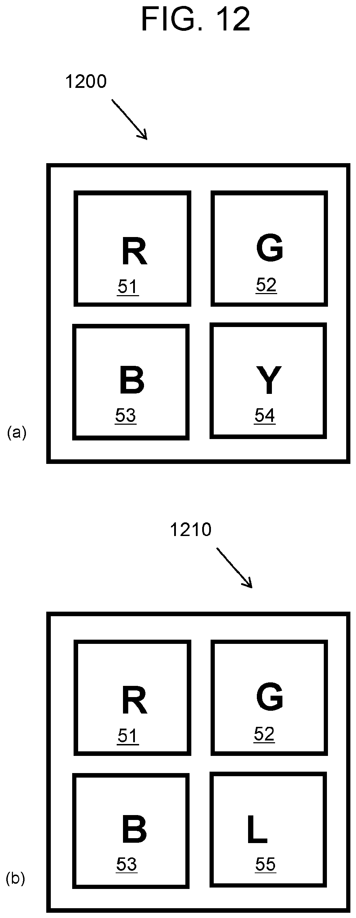

FIG. **12** depicts various configurations of sub-pixel layout and size for a pixel arrangement having four sub-pixels. In one embodiment, the pixel arrangement may comprise a fourth sub-pixel that emits yellow light. FIG. **12a** depicts pixel arrangement **1200,** which is an example embodiment of a pixel arrangement with four sub-pixels, where the first sub-pixel **510** is configured to emit red light, the second sub-pixel **520** is configured to emit green light, the third sub-pixel **530** is configured to emit blue light and the fourth sub-pixel **540** is configured to emit yellow light. Such a pixel arrangement may be of advantage in that a fourth sub-pixel that emits yellow light may broaden the colour gamut of a display into which it is incorporated. In particular, a broader range of yellow colours may be rendered by the display.

In one embodiment, the pixel arrangement may comprise a fourth sub-pixel that emits light blue light. FIG. **12b** depicts pixel arrangement **1210,** which is an example embodiment of a pixel arrangement with four sub-pixels, where the first sub-pixel **510** is configured to emit red light, the second sub-pixel **520** is configured to emit green light, the third sub-pixel **530** is configured to emit blue light and the fourth sub-pixel **550** is configured to emit light blue light. Such a pixel arrangement may be of advantage in that a fourth sub-pixel that emits light blue light may broaden the colour gamut of a display into which it is incorporated. In particular, a broader range of light blue colours may be rendered by the display.

In one embodiment, the pixel arrangement may be included in a display. Optionally, the display may be incorporated into a wide range of consumer products. Optionally, the display may be used in televisions, computer monitors, tablets, laptop computers, smart phones, cell phones, digital cameras, video recorders, smartwatches, fitness trackers, personal digital assistants, vehicle displays and other electronic devices. Optionally, the display may be used for micro-displays or heads-up displays. Optionally, the display may be used in light sources for interior or exterior illumination and/or signaling, in smart packaging or in billboards.

In one embodiment, the display is a flexible structure. Optionally, the display may be flexible with a flexural rigidity in the range of 0.1 Nm to 0.00001 Nm. Such a flexible display may be of advantage in that it may be less likely to suffer failure when subject to mechanical stress, when compared to an equivalent rigid structure. Such a flexible display may also be implemented more effectively in applications where curvature of the structure is required.

In one embodiment, at least one of the sub-pixels of the display includes a microcavity structure. In one embodiment, each of the sub-pixels of the display include a microcavity structure. Optionally, as described herein, a microcavity structure may be created where a transparent and partially reflective electrode is used in combination with an opposing reflective electrode. Optionally, in a standard device architecture, a bottom-emission microcavity structure may be created using a transparent and partially reflective multilayer anode such as ITO/Ag/ITO, where the Ag thickness is less than approximately 25nm, in combination with a reflective multilayer cathode such as LiF/Al. In this architecture, light emission is through the anode. Optionally, in a standard device architecture, a top-emission microcavity structure may be created using a transparent and partially reflective compound cathode such as Mg:Ag in combination with a reflective multilayer anode such as ITO/Ag/ITO, where the Ag thickness is greater than approximately 80nm. In this architecture, light emission is through the cathode.

Such a display may be of advantage in that one or more microcavity structures may increase the total amount of light emitted from one or more sub-pixels to which they are applied, thereby increasing the efficiency and brightness of the display. Such a display may further be of advantage in that one or more microcavity structures may increase the proportion of light emitted in the forward direction from one or more sub-pixels to which they are applied, thereby increasing the apparent brightness of the display to a user positioned at normal incidence. Such a display may further be of advantage in that one or more microcavity structures may narrow the spectrum of emitted light from one or more sub-pixels to which they are applied, thereby increasing the colour saturation of the emitted light and the colour gamut of the display. Application of one or more microcavity structures may thereby enable the display to render the DCI-P3 colour gamut. Application of one or more microcavity structures may thereby enable the display to render the Rec. 2020 colour gamut. Substantial similarity between anode and cathode properties required for PeLEDs, OLEDs and QLEDs facilitates the combination of these light emitting devices in a single device, such as a display.

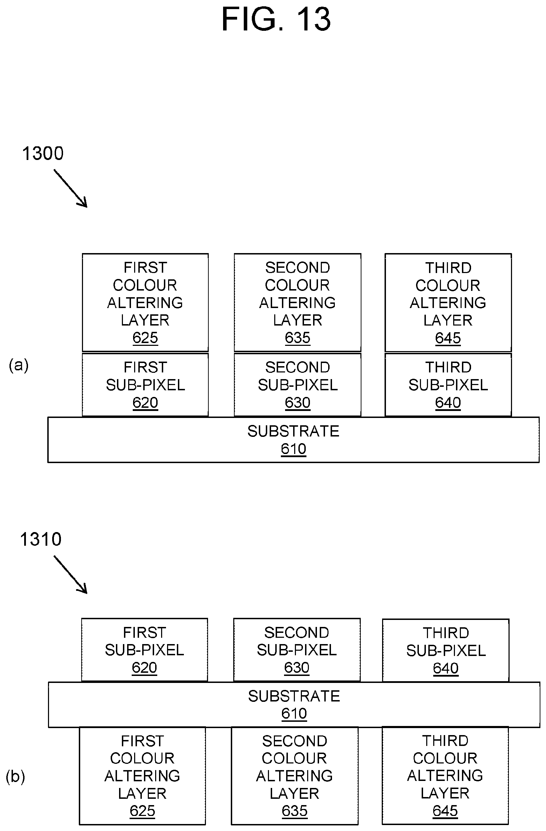

In one embodiment, each of the sub-pixels of the display include a colour altering layer. In one embodiment, at least one of the sub-pixels of the display includes a colour altering layer. As described herein, there are in general two classes of colour altering layers: colour filters that modify a spectrum by removing unwanted wavelengths of light, and colour changing layers that convert photons of higher energy to photons of lower energy. FIG. 13 depicts cross-sections of various configurations for a display comprising one or more colour altering layers.

FIG. **13a** depicts display **1300.** The display may comprise a substrate **610,** a first sub-pixel **620,** a second sub-pixel **630** and a third sub-pixel **640.** Optionally, display **1300** may comprise one or more colour altering layers. Optionally, display **1300** may comprise a first colour altering layer **625** optically coupled to and disposed over the first sub-pixel **620.** Optionally, display **1300** may comprise a second colour altering layer **635** optically coupled to and disposed over the second sub-pixel **630.** Optionally, display **1300** may comprise a third colour altering layer **645** optically coupled to and disposed over the third sub-pixel **440.** Optionally, one or more colour altering layers shown in FIG. **13a** may be omitted.

Optionally, the one or more colour altering layers may comprise one or more colour filters. Optionally, the one or more colour altering layers may comprise one or more colour changing layers. Optionally, the first, second and third sub-pixels of display **1300** may have the same surface area. Optionally, at least one of the first **620,** second **630** and third **640** sub-pixels has a surface area different from another of the first, second and third sub-pixels. Optionally, display **1300** may comprise further sub-pixels, such as a fourth sub-pixel, which may further comprise a fourth colour altering layer.

FIG. **13b** depicts display **1310.** The display may comprise a substrate **610,** a first sub-pixel **620,** a second sub-pixel **630** and a third sub-pixel **640.** Optionally, display **1310** may comprise one or more colour altering layers. Optionally, display **1310** may comprise a first colour altering layer **625** optically coupled to the first sub-pixel **620** through substrate **610.** Optionally, display **1310** may comprise a second colour altering layer **635** optically coupled to the second sub-pixel **630** through substrate **610.** Optionally, display **1310** may comprise a third colour altering layer **645** optically coupled to third sub-pixel **640** through substrate **610.** Optionally, one or more colour altering layers shown in FIG. **13b** may be omitted.

Optionally, the one or more colour altering layers may comprise one or more colour filters. Optionally, the one or more colour altering layers may comprise one or more colour changing layers. Optionally, the first, second and third sub-pixels of display **1310** may have the same surface area. Optionally, at least one of the first **620,** second **630** and third **640** sub-pixels has a surface area different from another of the first, second and third sub-pixels. Optionally, display **1310** may comprise further sub-pixels, such as a fourth sub-pixel, which may further comprise a fourth colour altering layer.

Such displays as depicted in FIG. **13** may be of advantage in that the inclusion of one or more colour altering layers may alter the spectrum of emitted light from one or more sub-pixels to which they are applied, thereby increasing the colour saturation of the emitted light and the colour gamut of the display. Application of one or more colour altering layers may thereby enable the display to render the DCI-P3 colour gamut. Application of one or more colour altering layers may thereby enable the display to render the Rec. 2020 colour gamut. Substantial similarity between colour altering layer properties required for PeLEDs, OLEDs and QLEDs facilitates the combination of these light emitting devices in a single device, such as a display.

In one embodiment, the display is capable of rendering the DCI-P3 colour gamut. That is to say that in one embodiment, one of the first, second and third sub-pixels of the display emits red light; one of the first, second and third sub-pixels of the display emits green light; and one of the first, second and third sub-pixels of the display emits blue light. In one embodiment, one of the first, second and third sub-pixels of the display emits red light with CIE 1931 x coordinate greater than or equal to 0.680; one of the first, second and third sub-pixels of the display emits green light with CIE 1931 y coordinate greater than or equal to 0.690; and one of the first, second and third sub-pixels of the display emits blue light with CIE 1931 y coordinate less than or equal to 0.060.

Such a display may be of advantage in that it fulfills colour gamut requirements of the DCI-P3 display standard. Such a display may be of advantage in that it may render a broader range of colours experienced in everyday life, thereby improving functionality and user experience.

In one embodiment, the display is capable of rendering the Rec. 2020 colour gamut. That is to say that in one embodiment, one of the first, second and third sub-pixels of the display emits red light; one of the first, second and third sub-pixels of the display emits green light; and one of the first, second and third sub-pixels of the display emits blue light. In one embodiment, one of the first, second and third sub-pixels of the display emits red light with CIE 1931 x coordinate greater than or equal to 0.708; one of the first, second and third sub-pixels of the display emits green light with CIE 1931 y coordinate greater than or equal to 0.797; and one of the first, second and third sub-pixels of the display emits blue light with CIE 1931 y coordinate less than or equal to 0.046.

Such a display may be of advantage in that it fulfills colour gamut requirements of the Rec. 2020 display standard. Such a display may be of advantage in that it may render a broader range of colours experienced in everyday life, thereby improving functionality and user experience.

A person skilled in the art will understand that only a few examples of use are described, but that they are in no way limiting.

Modifications to embodiments of the invention described in the foregoing are possible without departing from the scope of the invention as defined by the accompanying claims. Expressions such as "including", "comprising", "incorporating", "consisting of", "have", "is" used to describe and claim the present invention are intended to be construed in a non-exclusive manner, namely allowing for items, components or elements not explicitly described also to be present. Reference to the singular is also to be construed to relate to the plural. Any numerals included within parentheses in the accompanying claims are intended to assist understanding of the claims and should not be construed in any way to limit subject matter claimed by these claims.

### Patent References

US 8773013 B2, Rajan et al., Three Dimensional OLED Lamps
EP 0423283 B1, Friend et al., Electroluminescent Devices
US 6303238 B1, Thompson et al., OLEDs Doped with Phosphorescent Compounds
US 7279704 B2, Walters et al., Complexes with Tridentate Ligands

### Other References

S. Adjokatse et al., Broadly tunable metal halide perovskites for solid-state light-emission applications, Material Today, Volume 20, Issue 8, Pages 413-424 (2017).
Uoyama et al., Highly efficient organic light-emitting diodes from delayed fluorescence, Nature, Volume 492, Pages 234-238 (2012).
Kathirgamanathan et al. (1), Electroluminescent Organic and Quantum Dot LEDs: The State of the Art, Journal of Display Technology, Volume 11, Number 5, Pages 480-493 (2015).
Soneira et al., iPhone X OLED Display Technology Shoot-Out, DisplayMate Technologies Corporation, http://www.displaymate.com/iPhoneX ShootOut 1a.htm [accessed 20 April, 2018]
Wang et al., Perovskite light-emitting diodes based on solution-processed, self-organised multiple quantum wells, Nature Photonics, Volume 10, Pages 699-704 (2016).
Kathirgamanathan et al. (2), Quantum Dot Electroluminescence: Towards Achieving the REC 2020 Colour Co-ordinates, SID Symposium Digest of Technical Papers 2015, Volume 47, Pages 652-656 (2016).
Hirose et al., High-efficiency Perovskite QLED Achieving BT.2020 Green Chromaticity, SID Symposium Digest of Technical Papers 2017, Volume 48, Pages 284-287 (2017).
Kumar et al., Efficient Blue Electroluminescence Using Quantum-Confined Two-Dimensional Perovskites, ACS Nano, Volume 10, Pages 9720-9729 (2016).
Takita et al., Highly efficient deep-blue fluorescent dopant for achieving low-power OLED display satisfying BT.2020 chromaticity, Journal of the SID 2018 (2018).

## Claims

1. A pixel arrangement for a display, the arrangement comprising a plurality of pixels, each pixel comprising:
a first sub-pixel configured to emit a first colour of light;
a second sub-pixel configured to emit a second colour of light that is different from the first colour of light; and
a third sub-pixel configured to emit a third colour of light that is different from the first and second colour of light,
wherein the first sub-pixel comprises a perovskite light emitting diode (PeLED), the second sub-pixel comprises a PeLED or a quantum dot light emitting diode (QLED), the third sub-pixel comprises a PeLED or a QLED, and at least one of the second sub-pixel and the third sub-pixel comprises a QLED;
wherein each PeLED comprises an electroluminescent perovskite light emitting material; and
wherein each QLED comprises an electroluminescent quantum dot light emitting material that is not a perovskite material.

2. The pixel arrangement of claim 1, wherein the second sub-pixel comprises a PeLED and the third sub-pixel comprises a QLED.

3. The pixel arrangement of claim 1, wherein the second sub-pixel comprises a QLED, and the third sub-pixel comprises a QLED.

4. The pixel arrangement of any one of the preceding claims, wherein
one of the first, second and third sub-pixels emits red light;
one of the first, second and third sub-pixels emits green light; and
one of the first, second and third pixels emits blue light.

5. The pixel arrangement of claim 4, wherein
one of the first, second and third sub-pixels emits red light with CIE 1931 x coordinate greater than or equal to 0.680;
one of the first, second and third sub-pixels emits green light with CIE 1931 y coordinate greater than or equal to 0.690; and
one of the first, second and third sub-pixels emits blue light with CIE 1931 y coordinate less than or equal to 0.060.

6. The pixel arrangement of claim 4, wherein
one of the first, second and third sub-pixels emits red light with CIE 1931 x coordinate greater than or equal to 0.708;
one of the first, second and third sub-pixels emits green light with CIE 1931 y coordinate greater than or equal to 0.797; and
one of the first, second and third sub-pixels emits blue light with CIE 1931 y coordinate less than or equal to 0.046.

7. The pixel arrangement of any one of the preceding claims, wherein each of the first, second and third sub-pixels have the same surface area.

8. The pixel arrangement of any one of claims 1 to 6, wherein at least one of the first, second and third sub-pixels has a surface area different from another of the first, second and third sub-pixels.

9. The pixel arrangement of any one of the preceding claims, wherein the pixel arrangement further comprises a fourth sub-pixel configured to emit a fourth colour of light that is different from the first, second and third colour of light, the fourth sub-pixel comprising a PeLED, an OLED or a QLED.

10. The pixel arrangement of any one of the preceding claims, wherein one or more of the PeLEDs comprise organic metal halide light-emitting perovskite material.

11. The pixel arrangement of any one of the preceding claims, wherein one or more of the PeLEDs comprise inorganic metal halide light-emitting perovskite material.

12. A display comprising the pixel arrangement of any one of the preceding claims.

13. The display of claim 12, wherein the display is part of a consumer product.

## Patentansprüche

1. Pixelanordnung für eine Anzeige, wobei die Anordnung eine Vielzahl von Pixeln umfasst, wobei jedes Pixel Folgendes umfasst:
ein erstes Subpixel, das dazu konfiguriert ist, Licht einer ersten Farbe zu emittieren;
ein zweites Subpixel, das dazu konfiguriert ist, Licht einer zweiten Farbe zu emittieren, wobei die zweite Farbe sich von der ersten Farbe unterscheidet; und
ein drittes Subpixel, das dazu konfiguriert ist, Licht einer dritten Farbe zu emittieren, wobei sich die dritte Farbe von der ersten und der zweiten Farbe unterscheidet,
wobei das erste Subpixel eine Perowskit-Leuchtdiode (PeLED) umfasst, das zweite Subpixel eine PeLED oder eine Quantenpunkt-Leuchtdiode (QLED) umfasst, das dritte Subpixel eine PeLED oder eine QLED umfasst, und wobei mindestens eines der zweiten und dritten Subpixel eine QLED umfasst;
wobei jede PeLED ein elektrolumineszentes lichtemittierendes Perowskitmaterial umfasst; und
wobei jede QLED ein elektrolumineszentes lichtemittierendes Quantenpunktmaterial umfasst, das kein Perowskitmaterial ist.

2. Pixelanordnung nach Anspruch 1, wobei das zweite Subpixel eine PeLED umfasst und das dritte Subpixel eine QLED umfasst.

3. Pixelanordnung nach Anspruch 1, wobei das zweite Subpixel eine QLED umfasst und das dritte Subpixel eine QLED umfasst.

4. Pixelanordnung nach einem der vorstehenden Ansprüche, wobei
eines der ersten, zweiten und dritten Subpixel rotes Licht emittiert;
eines der ersten, zweiten und dritten Subpixel grünes Licht emittiert; und
eines der ersten, zweiten und dritten Subpixel blaues Licht emittiert.

5. Pixelanordnung nach Anspruch 4, wobei
eines der ersten, zweiten und dritten Subpixel rotes Licht mit einem CIE-1931-x-Koordinatenwert größer oder gleich 0,680 emittiert;
eines der ersten, zweiten und dritten Subpixel grünes Licht mit einem CIE-1931-y-Koordinatenwert größer oder gleich 0,690 emittiert; und
eines der ersten, zweiten und dritten Subpixel blaues Licht mit einem CIE-1931-y-Koordinatenwert kleiner oder gleich 0,060 emittiert.

6. Pixelanordnung nach Anspruch 4, wobei
eines der ersten, zweiten und dritten Subpixel rotes Licht mit einem CIE-1931-x-Koordinatenwert größer oder gleich 0,708 emittiert;
eines der ersten, zweiten und dritten Subpixel grünes Licht mit einem CIE-1931-y-Koordinatenwert größer oder gleich 0,797 emittiert; und
eines der ersten, zweiten und dritten Subpixel blaues Licht mit einem CIE-1931-y-Koordinatenwert kleiner oder gleich 0,046 emittiert.

7. Pixelanordnung nach einem der vorstehenden Ansprüche, wobei jedes der ersten, zweiten und dritten Subpixel dieselbe Oberfläche aufweist.

8. Pixelanordnung nach einem der Ansprüche 1 bis 6, wobei mindestens eines der ersten, zweiten und dritten Subpixel eine andere Oberfläche aufweist als ein anderes der ersten, zweiten und dritten Subpixel.

9. Pixelanordnung nach einem der vorstehenden Ansprüche, wobei die Pixelanordnung weiter ein viertes Subpixel umfasst, das dazu eingerichtet ist, Licht einer vierten Farbe zu emittieren, die sich von der ersten, zweiten und dritten Farbe unterscheidet, wobei das vierte Subpixel eine PeLED, eine OLED oder eine QLED umfasst.

10. Pixelanordnung nach einem der vorstehenden Ansprüche, wobei eine oder mehrere der PeLEDs organisches metallhalogenid-haltiges lichtemittierendes Perowskitmaterial umfassen.

11. Pixelanordnung nach einem der vorstehenden Ansprüche, wobei eine oder mehrere der PeLEDs anorganisches metallhalogenid-haltiges lichtemittierendes Perowskitmaterial umfassen.

12. Anzeige, die die Pixelanordnung nach einem der vorstehenden Ansprüche umfasst.

13. Anzeige nach Anspruch 12, wobei die Anzeige Teil eines Konsumguts ist.

## Revendications

1. Agencement de pixels pour un affichage, l'agencement comprenant une pluralité de pixels, chaque pixel comprenant :
un premier sous-pixel configuré pour émettre une première couleur de lumière ;
un deuxième sous-pixel configuré pour émettre une deuxième couleur de lumière qui est différente de la première couleur de lumière ; et
un troisième sous-pixel configuré pour émettre une troisième couleur de lumière qui est différente de la première et de la deuxième couleur de lumière,
dans lequel le premier sous-pixel comprend une diode émettrice de lumière à pérovskite (PeLED), le deuxième sous-pixel comprend une PeLED ou une diode émettrice de lumière à points quantiques (QLED), le troisième sous-pixel comprend une PeLED ou une QLED, et au moins un du deuxième sous-pixel et du troisième sous-pixel comprend une QLED ;
dans lequel chaque PeLED comprend un matériau émetteur de lumière à pérovskite électroluminescent ; et
dans lequel chaque QLED comprend un matériau émetteur de lumière à points quantiques électroluminescent qui n'est pas un matériau à pérovskite.

2. Agencement de pixels selon la revendication 1, dans lequel le deuxième sous-pixel comprend une PeLED et le troisième sous-pixel comprend une QLED.

3. Agencement de pixels selon la revendication 1, dans lequel le deuxième sous-pixel comprend une QLED, et le troisième sous-pixel comprend une QLED.

4. Agencement de pixels selon l'une quelconque des revendications précédentes, dans lequel
un des premier, deuxième et troisième sous-pixels émet une lumière rouge ;
un des premier, deuxième et troisième sous-pixels émet une lumière verte ; et
un des premier, deuxième et troisième sous-pixels émet une lumière bleue.

5. Agencement de pixels selon la revendication 4, dans lequel
un des premier, deuxième et troisième sous-pixels émet une lumière rouge avec une coordonnée CIE 1931 x supérieure ou égale à 0,680 ;
un des premier, deuxième et troisième sous-pixels émet une lumière verte avec une coordonnée CIE 1931 y supérieure ou égale à 0,690 ; et
un des premier, deuxième et troisième sous-pixels émet une lumière bleue avec une coordonnée CIE 1931 y inférieure ou égale à 0,060.

6. Agencement de pixels selon la revendication 4, dans lequel
un des premier, deuxième et troisième sous-pixels émet une lumière rouge avec une coordonnée CIE 1931 x supérieure ou égale à 0,708 ;
un des premier, deuxième et troisième sous-pixels émet une lumière verte avec une coordonnée CIE 1931 y supérieure ou égale à 0,797 ; et
un des premier, deuxième et troisième sous-pixels émet une lumière bleue avec une coordonnée CIE 1931 y inférieure ou égale à 0,046.

7. Agencement de pixels selon l'une quelconque des revendications précédentes, dans lequel chacun des premier, deuxième et troisième sous-pixels présente la même aire.

8. Agencement de pixels selon l'une quelconque des revendications 1 à 6, dans lequel au moins un des premier, deuxième et troisième sous-pixels présente une aire différente d'une autre des premier, deuxième et troisième sous-pixels.

9. Agencement de pixels selon l'une quelconque des revendications précédentes, dans lequel l'agencement de pixels comprend en outre un quatrième sous-pixel configuré pour émettre une quatrième couleur de lumière qui est différente des première, deuxième et troisième couleurs de lumière, le quatrième sous-pixel comprenant une PeLED, une OLED ou une QLED.

10. Agencement de pixels selon l'une quelconque des revendications précédentes, dans lequel une ou plusieurs des PeLED comprennent un matériau à pérovskite émetteur de lumière d'halogénure métallique organique.

11. Agencement de pixels selon l'une quelconque des revendications précédentes, dans lequel une ou plusieurs des PeLED comprennent un matériau à pérovskite émetteur de lumière d'halogénure métallique inorganique.

12. Affichage comprenant l'agencement de pixels selon l'une quelconque des revendications précédentes.

13. Affichage selon la revendication 12, dans lequel l'affichage fait partie d'un produit de consommation.
